(19) **Europäisches Patentamt**
**European Patent Office**
**Office européen des brevets**

(11) **EP 4 107 535 B1**

(12) **EUROPÄISCHE PATENTSCHRIFT**

(45) Veröffentlichungstag und Bekanntmachung des Hinweises auf die Patenterteilung:
**04.06.2025 Patentblatt 2025/23**

(21) Anmeldenummer: **20830201.8**

(22) Anmeldetag: **18.12.2020**

(51) Internationale Patentklassifikation (IPC):
**G01R 31/26** (2020.01) **G01R 31/333** (2006.01)
**H03K 17/18** (2006.01)

(52) Gemeinsame Patentklassifikation (CPC):
**G01R 31/2621; G01R 31/333; H03K 17/18**

(86) Internationale Anmeldenummer:
**PCT/EP2020/087019**

(87) Internationale Veröffentlichungsnummer:
**WO 2021/164927 (26.08.2021 Gazette 2021/34)**

(54) **SYSTEM UND VERFAHREN ZUM ERKENNEN VON NICHT SCHALTENDEN HALBLEITERSCHALTERN**

SYSTEM AND METHOD FOR IDENTIFYING NON-SWITCHING SEMICONDUCTOR SWITCHES

SYSTÈME ET PROCÉDÉ DESTINÉS À IDENTIFIER DES COMMUTATEURS SEMI-CONDUCTEURS SANS COMMUTATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.02.2020 DE 102020104110**

(43) Veröffentlichungstag der Anmeldung:
**28.12.2022 Patentblatt 2022/52**

(73) Patentinhaber: **LEONI Bordnetz-Systeme GmbH 97318 Kitzingen (DE)**

(72) Erfinder: **KOCH, Wolfgang 97320 Buchbrunn (DE)**

(74) Vertreter: **Frenkel, Matthias Alexander Wuesthoff & Wuesthoff Patentanwälte und Rechtsanwalt PartG mbB Schweigerstraße 2 81541 München (DE)**

(56) Entgegenhaltungen:
**EP-A1- 2 645 511 EP-A1- 3 460 593 DE-A1- 102012 219 243**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft im Allgemeinen das Erkennen von nicht schaltenden Halbleiterschaltern. Im Speziellen betrifft die vorliegende Erfindung ein System sowie ein Verfahren zum Erkennen eines nicht schaltenden Halbleiterschalters.

In elektronischen Leistungsverteilern, insbesondere in solchen mit hohen Anforderungen an die funktionale Sicherheit, ist es von besonderer Bedeutung, dass der Gesundheitszustand, auch oftmals als State of Health (SoH) bezeichnet, der verwendeten Leistungshalbleiter zu möglichst jedem Zeitpunkt bekannt ist. Hierfür ist es wichtig zu wissen, ob ein als Schalter dienender Leistungshalbleiter während des laufenden Betriebs in der Lage ist, auf jeden Fall sicher schalten, insbesondere abschalten, zu können. Ist dies nicht möglich, so besteht nur die Möglichkeit dem Leistungshalbleiter einen zweiten Leistungshalbleiter in Reihe zu schalten. Dies erhöht jedoch die Kosten, den Platzbedarf und die Verlustleistung eines Strompfads. Ferner wird durch die Reihenschaltung eines zweiten Leistungshalbleiters lediglich die Wahrscheinlichkeit eines Fehlversagens des Strompfads statistisch gesenkt. Eine tatsächliche Überprüfung und/oder Diagnose eines erfolgreichen Schaltvorgangs des Halbleiters ist nur durch ein Abschalten des Halbleiters möglich.

Die DE 43 01 605 C1 offenbart ein Verfahren und eine Anordnung zum Überwachen des Ein- und Ausschaltens eines steuerbaren Leistungshalbleiterbauelements in einer leistungselektronischen Schaltung. Bei einem Ansteuerungssignal zur Einschaltung des Leistungshalbleiterbauelements werden aus Pegelwechseln des die Gate-Elektrode beaufschlagenden Signals und den Pegelwechseln an einer Ausgangselektrode beim Umschalten des Leistungshalbleiterbauelements Zählsignale gebildet. Die Zählsignale werden in einem ersten Zähler aufsummiert und mit einem der einwandfreien Arbeitsweise des Leistungshalbleiterbauelements zugeordneten, vorgegebenen Zählwert verglichen. Bei einem Unterschied zwischen der Summe der Zählsignale und dem vorgegebene Zählwert wird ein Fehler gemeldet.

Dieses Verfahren und die zugehörige Anordnung sind zumindest insofern nachteilig, als dass sie nur bei ständig schaltenden Schaltern funktionieren. Im statischen Betrieb kann das System nicht unmittelbar einen Fehler diagnostizieren. Das Verfahren und die Anordnung der DE 43 01 605 C1 sind daher insbesondere im statischen Betrieb für die Fehlererkennung nicht zuverlässig genug.

Die EP 2 645 511 A1 betrifft ein Verfahren und eine Schaltungsanordnung zum Überprüfen der Funktionalität einer Notfallabschaltung. Hierfür sind zu einem Lastausgang wenigstens 2 parallele Ausgangsschalter vorgesehen, die abwechselnd in und außer Betrieb genommen werden. Der außer Betrieb genommene Ausgangsschalter wird auf Zuverlässigkeit des Abschaltens der Last überprüft.

EP 3 460 593 A1 betrifft ein Verfahren und eine Schaltvorrichtung zum Schalten eines Signals auf einer Verbindung zwischen einem ersten Punkt und einem zweiten Punkt.

Es besteht daher ein Bedarf nach einem zuverlässigen und genauen Erkennen nicht schaltender Halbleiterschalter. Das Erkennen sollte insbesondere möglich sein, ohne dabei eine dazugehörige Last abschalten zu müssen.

Gemäß einem ersten Aspekt der Erfindung entsprechend Anspruch 1 wird ein System zum Erkennen eines nicht schaltenden Halbleiterschalters bereitgestellt. Das System weist einen ersten Halbleiterschalter, ein erstes Halbleiterbauelement, einen zweiten Halbleiterschalter, ein zweites Halbleiterbauelement, einen ersten Widerstand, einen zweiten Widerstand und eine Ermittlungseinheit auf. Der erste Halbleiterschalter ist mittels eines ersten Ansteuersignals ansteuerbar. Das erste Halbleiterbauelement ist ausgebildet und angeordnet, einen Stromfluss durch das erste Halbleiterbauelement zumindest in eine Richtung zu verhindern. Der zweite Halbleiterschalter ist mittels eines zweiten Ansteuersignals ansteuerbar. Das zweite Halbleiterbauelement ist ausgebildet und angeordnet, einen Stromfluss durch das zweite Halbleiterbauelement zumindest in eine Richtung zu verhindern.

Ein Ende des ersten Widerstands ist zwischen den ersten Halbleiterschalter und das erste Halbleiterbauelement geschaltet. Ein anderes Ende des ersten Widerstands ist mit einem Bezugspotential, beispielsweise mit Masse, verbunden. Ein Ende des zweiten Widerstands ist zwischen den zweiten Halbleiterschalter und das zweite Halbleiterbauelement geschaltet. Ein anderes Ende des zweiten Widerstands ist mit dem Bezugspotential, beispielsweise mit Masse, verbunden. Die Ermittlungseinheit ist ausgebildet, basierend auf einem Verlauf einer ersten, über dem ersten Widerstand abfallenden Spannung zu erkennen, ob der erste Halbleiterschalter nicht schaltet. Die Ermittlungseinheit ist ausgebildet, basierend auf einem Verlauf einer zweiten, über dem zweiten Widerstand abfallenden Spannung zu erkennen, ob der zweite Halbleiterschalter nicht schaltet.

Auf diese Weise kann einfach und genau ermittelt werden, ob zumindest einer der beiden Halbleiterschalter nicht schaltet. Der Verlauf ist insbesondere ein zeitlicher Verlauf.

Beispielsweise kann die Ermittlungseinheit ausgebildet sein, unmittelbar anhand des (zeitlichen) Verlaufs oder ausschließlich aus dem (zeitlichen) Verlauf der ersten Spannung zu erkennen, ob der erste Halbleiterschalter korrekt schaltet. Ferner kann die Ermittlungseinheit ausgebildet sein, basierend auf dem (zeitlichen) Verlauf der ersten Spannung ein Ausgangssignal zu ermitteln, das ein Erkennen eines Fehlers beim Schalten des ersten Halbleiterschalters gestattet/ermöglicht. Beispielsweise kann die Ermittlungseinheit ausgebildet sein, unmittelbar anhand des (zeitlichen) Verlaufs oder ausschließlich aus dem (zeitlichen) Verlauf der zweiten Spannung zu erkennen, ob der zweite Halbleiterschalter korrekt schaltet. Ferner kann die Ermittlungseinheit ausgebildet sein, basierend auf dem (zeitlichen) Verlauf der zweiten Spannung ein Ausgangssignal zu ermitteln, das ein Erkennen eines Fehlers beim Schalten des zweiten Halbleiterschalters gestattet/ermöglicht.

Der erste Halbleiterschalter kann einen geöffneten/offenen Schaltzustand und einen geschlossenen Schaltzustand einnehmen. Der erste Halbleiterschalter kann mittels des ersten Ansteuersignals von dem offenen Schaltzustand in den geschlossenen Schaltzustand überführt werden und umgekehrt. Hierfür kann das erste Ansteuersignal an einen Anschluss, beispielsweise (im Fall eines Feldeffekttransistors) einen Gate-Anschluss, des ersten Halbleiterschalters angelegt werden.

Die Ermittlungseinheit kann ausgebildet sein, einen Fehler beim Schalten des ersten Halbleiterschalters von einem geschlossenen in einen offenen Schaltzustand zu erkennen. Zusätzlich oder alternativ kann die Ermittlungseinheit ausgebildet sein, einen Fehler beim Schalten des zweiten Halbleiterschalters von einem geschlossenen in einen offenen Schaltzustand zu erkennen. Die Ermittlungseinheit kann ausgebildet sein, basierend auf dem Verlauf der ersten Spannung zu erkennen, ob der erste Halbleiterschalter korrekt von dem geschlossenen Schaltzustand in den offenen Schaltzustand schaltet. Die Ermittlungseinheit kann ausgebildet sein, basierend auf dem Verlauf der ersten Spannung zu erkennen, ob der erste Halbleiterschalter korrekt von dem offenen Schaltzustand in den geschlossenen Schaltzustand schaltet. Anders ausgedrückt kann von der Ermittlungseinheit erkannt werden, ob der erste und/oder der zweite Halbleiterschalter (korrekt) von einem geschlossenen in einen offenen Schaltzustand überführbar ist oder nicht.

Der zweite Halbleiterschalter kann einen geöffneten/offenen Schaltzustand und einen geschlossenen Schaltzustand einnehmen. Der zweite Halbleiterschalter kann mittels des zweiten Ansteuersignals von dem offenen Schaltzustand in den geschlossenen Schaltzustand überführt werden und umgekehrt. Hierfür kann das zweite Ansteuersignal an einen Anschluss, beispielsweise (im Fall eines Feldeffekttransistors) einen Gate-Anschluss, des zweiten Halbleiterschalters angelegt werden.

Die Ermittlungseinheit kann ausgebildet sein, einen Fehler beim Schalten des ersten Halbleiterschalters von einem offenen in einen geschlossenen Schaltzustand zu erkennen. Zusätzlich oder alternativ kann die Ermittlungseinheit ausgebildet sein, einen Fehler beim Schalten des zweiten Halbleiterschalters von einem offenen in einen geschlossenen Schaltzustand zu erkennen. Die Ermittlungseinheit kann ausgebildet sein, basierend auf dem Verlauf der zweiten Spannung zu erkennen, ob der zweite Schalter korrekt von dem geschlossenen Schaltzustand in den offenen Schaltzustand schaltet. Die Ermittlungseinheit kann ausgebildet sein, basierend auf dem Verlauf der zweiten Spannung zu erkennen, ob der zweite Schalter korrekt von dem offenen Schaltzustand in den geschlossenen Schaltzustand schaltet. Anders ausgedrückt kann von der Ermittlungseinheit erkannt werden, ob der erste und/oder der zweite Halbleiterschalter (korrekt) von einem offenen in einen geschlossenen Schaltzustand überführbar ist oder nicht.

Das System zum Erkennen eines nicht schaltenden Halbleiterschalters kann demnach alternativ auch als System zum Erkennen eines Fehlers beim Schalten eines Halbleiterschalters bezeichnet werden. Der Fehler kann beispielsweise manuell erkannt werden, indem der Verlauf der ersten und/oder zweiten Spannung oder ein von dem Verlauf der ersten und/oder zweiten Spannung abgeleitetes Signal betrachtet wird. Alternativ kann der Fehler automatisiert von einer Erkennungskomponente anhand des Verlaufs der ersten und/oder zweiten Spannung oder eines von dem Verlauf der ersten und/oder zweiten Spannung abgeleiteten Signals erkannt werden. Das System kann ferner die Erkennungskomponente aufweisen. Die Erkennungskomponente kann ausgebildet sein, den Fehler beim Schalten des ersten Halbleiterschalters basierend auf dem Ausgangssignal zu erkennen. Zusätzlich oder alternativ kann die Erkennungskomponente ausgebildet sein, den Fehler beim Schalten des zweiten Halbleiterschalters basierend auf dem Ausgangssignal zu erkennen.

Zum Erfassen der über dem ersten Widerstand abfallenden ersten Spannung kann eine erste Spannungserfassungskomponente, z.B. ein Spannungsmesser/Voltmeter, vorgesehen sein. Die erste Spannungserfassungskomponente kann ausgebildet sein, den Verlauf der ersten, über dem ersten Widerstand abfallenden Spannung zu erfassen. Der erste Widerstand kann Teil eines ersten Spannungsteilers / einer ersten Spannungsteilerschaltung sein. Zum Erfassen der über dem zweiten Widerstand abfallenden zweiten Spannung kann eine zweite Spannungserfassungskomponente, z.B. ein Spannungsmesser/Voltmeter, vorgesehen sein. Die zweite Spannungserfassungskomponente kann ausgebildet sein, den Verlauf der zweiten, über dem zweiten Widerstand abfallenden Spannung zu erfassen. Der zweite Widerstand kann Teil eines zweiten Spannungsteilers / einer zweiten Spannungsteilerschaltung sein.

Das erste Halbleiterbauelement kann als Halbleiterdiode ausgebildet sein. Die Halbleiterdiode wird im Folgenden als erste Halbleiterdiode bezeichnet. Die erste Halbleiterdiode kann mit dem ersten Halbleitschalter ein erstes Halbleiterbauelement-Paar bilden. Die erste Halbleiterdiode kann angeordnet sein, mit dem ersten Widerstand einen ersten Pfad zu bilden, wenn der erste Halbleiterschalter sich in einem offenen Zustand befindet. Die erste Halbleiterdiode kann ausgebildet sein, einen Stromfluss durch den gebildeten ersten Pfad zu verhindern, wenn sich der erste Halbleiterschalter in dem offenen Zustand befindet. Da ein Ende des ersten Widerstands - unabhängig davon, ob der erste Widerstand Teil eines ersten Spannungsteilers ist oder nicht - zwischen den ersten Halbleiterschalter und die erste Halbleiterdiode geschaltet ist, bilden der Widerstand und die erste Halbleiterdiode als ersten Pfad eine Reihenschaltung, wenn der erste Halbleiterschalter sich in einem offenen Schaltzustand befindet. In diesem Fall könnte über das erste Halbleiterbauelement ein Strom in den ersten Widerstand fließen und das Ergebnis der Ermittlungseinheit, ob der erste Halbleiterschalter korrekt schaltet, verfälschen. Um diese Verfälschung zu verringern oder sogar zu verhindern, kann die erste Halbleiterdiode angeordnet sein, einen Stromfluss durch die erste Halbleiterdiode in Richtung des, bei geöffnetem ersten Halbleiterschalter, in Reihe geschalteten ersten Widerstands zu verhindern. Auf diese Weise kann die Genauigkeit der Ermittlung erhöht werden.

Das zweite Halbleiterbauelement kann als Halbleiterdiode ausgebildet sein. Die Halbleiterdiode wird im Folgenden als zweite Halbleiterdiode bezeichnet. Die zweite Halbleiterdiode kann mit dem zweiten Halbleitschalter ein zweites Halbleiterbauelement-Paar bilden. Die zweite Halbleiterdiode kann angeordnet sein, mit dem zweiten Widerstand einen zweiten Pfad zu bilden, wenn der zweite Halbleiterschalter sich in einem offenen Zustand befindet. Die zweite Halbleiterdiode kann ausgebildet sein, einen Stromfluss durch den gebildeten zweiten Pfad zu verhindern, wenn sich der zweite Halbleiterschalter in dem offenen Zustand befindet. Da ein Ende des zweiten Widerstands zwischen dem zweiten Halbleiterschalter und der zweiten Halbleiterdiode geschaltet ist, bilden der Widerstand und die zweite Halbleiterdiode als zweiten Pfad eine Reihenschaltung, wenn der zweite Halbleiterschalter sich in einem offenen Schaltzustand befindet. In diesem Fall könnte über das zweite Halbleiterbauelement ein Strom in den zweiten Widerstand fließen und das Ergebnis der Ermittlungseinheit, ob der zweite Halbleiterschalter korrekt schaltet, verfälschen. Um diese Verfälschung zu verringern oder sogar zu verhindern, kann die zweite Halbleiterdiode angeordnet sein, einen Stromfluss durch die zweite Halbleiterdiode in Richtung des, bei geöffnetem zweiten Halbleiterschalter, in Reihe geschalteten zweiten Widerstands zu verhindern. Auf diese Weise kann die Genauigkeit der Ermittlung erhöht werden.

Das erste Halbleiterbauelement kann als Halbleiterschalter ausgebildet sein. Das als Halbleiterschalter ausgebildete erste Halbleiterbauelement kann antiseriell mit dem ersten Halbleiterschalter geschaltet/verschaltet sein. Unter antiseriell kann hierbei verstanden werden, dass die zwei Bauteile (d.h. die Halbleiterschalter) in entgegengesetzter Polung in Reihe geschaltet sind. Die beiden auf diese Weise verschalteten Halbleiterschalter können ein erstes Halbleiterschalter-Paar bilden und als ein solches bezeichnet werden. Die Halbleiterschalter des ersten Halbleiterschalter-Paars können mit dem ersten Ansteuersignal angesteuert werden. Beispielsweise kann jeweils der gleiche Anschluss, beispielsweise der Gate-Anschluss, der Halbleiterschalter des ersten Halbleiterschalter-Paars von dem ersten Ansteuersignal angesteuert werden.

Das zweite Halbleiterbauelement kann als Halbleiterschalter ausgebildet sein. Das als Halbleiterschalter ausgebildete zweite Halbleiterbauelement kann antiseriell mit dem zweiten Halbleiterschalter geschaltet/verschaltet sein. Unter antiseriell kann hierbei verstanden werden, dass die zwei Bauteile (d.h. die Halbleiterschalter) in entgegengesetzter Polung in Reihe geschaltet sind. Die beiden auf diese Weise verschalteten Halbleiterschalter können ein zweites Halbleiterschalter-Paar bilden und als eines solches bezeichnet werden. Die Halbleiterschalter des zweiten Halbleiterschalter-Paars können mit dem zweiten Ansteuersignal angesteuert werden. Beispielsweise kann jeweils der gleiche Anschluss, beispielsweise der Gate-Anschluss, der Halbleiterschalter des zweiten Halbleiterschalter-Paars von dem zweiten Ansteuersignal angesteuert werden.

Das System kann eine erste Spannungsteilerschaltung aufweisen. Die erste Spannungsteilerschaltung kann den ersten Widerstand und mindestens einen weiteren Widerstand aufweisen. Ein Ende der ersten Spannungsteilerschaltung kann zwischen den ersten Halbleiterschalter und das erste Hableiterbauelement geschaltet sein. Ein anderes Ende der ersten Spannungsteilerschaltung kann mit einem Bezugspotential, beispielsweise mit Masse, verbunden sein. Bei dem ersten Widerstand kann es sich beispielsweise um den Widerstand der Spannungsteilerschaltung handeln, der mit dem Bezugspotential, beispielsweise mit Masse, direkt/unmittelbar verbunden ist. Mit Hilfe der Spannungsteilerschaltung kann die Spannung über dem ersten Widerstand beispielsweise auf einen Wert gebracht/reduziert werden, der in eine, unten erläuterte, erste Vergleichskomponente eingegeben und von dieser verarbeitet werden kann.

Das System kann eine zweite Spannungsteilerschaltung aufweisen. Die zweite Spannungsteilerschaltung kann den zweiten Widerstand und mindestens einen weiteren Widerstand aufweisen. Ein Ende der zweiten Spannungsteilerschaltung kann zwischen den zweiten Halbleiterschalter und das zweite Hableiterbauelement geschaltet sein. Ein anderes Ende der zweiten Spannungsteilerschaltung kann mit einem Bezugspotential, beispielsweise mit Masse, verbunden sein. Bei dem zweiten Widerstand kann es sich beispielsweise um den Widerstand der Spannungsteilerschaltung handeln, der mit dem Bezugspotential, beispielsweise mit Masse, direkt/unmittelbar verbunden ist. Mit Hilfe der Spannungsteilerschaltung kann die Spannung über dem zweiten Widerstand beispielsweise auf einen Wert gebracht/reduziert werden, der in eine, unten erläuterte, zweite Vergleichskomponente eingegeben und von dieser verarbeitet werden kann.

Die Ermittlungseinheit weist eine erste Vergleichskomponente auf. Die erste Vergleichskomponente ist dazu ausgebildet, einen ersten Vergleichsverlauf zu ermitteln durch Vergleichen des Verlaufs der ersten Spannung mit einem Verlauf einer über einem Referenzwiderstand abfallenden Referenzspannung. Ein Ende des Referenzwiderstands kann mit einer Spannungsquelle verbunden sein. Ein anderes Ende des Referenzwiderstands kann mit einem/dem Bezugspotential, beispielswiese mit Masse, verbunden sein. Die Spannungsquelle kann mit dem ersten Halbleiterschalter, dem ersten Halbleiterbauelement, dem zweiten Halbleiterschalter und/oder dem zweite Halbleiterbauelement verbunden sein.

Das System kann einen Referenzspannungsteiler aufweisen. Der Referenzspannungsteiler kann den Referenzwiderstand und zumindest einen weiteren Widerstand aufweisen. Anders ausgedrückt kann der Referenzwiderstand Teil des Referenzspannungsteilers sein. Ein Ende des Referenzspannungsteilers kann mit einer oder der Spannungsquelle verbunden sein. Ein anderes Ende des Referenzspannungsteilers kann mit dem Bezugspotential, beispielswiese mit Masse, verbunden sein. Bei dem Referenzwiderstand kann es sich beispielsweise um den Widerstand des Referenzspannungsteilers handeln, der mit dem Bezugspotential, beispielsweise mit Masse, direkt/unmittelbar verbunden ist.

Die erste Vergleichskomponente kann einen ersten Komparator aufweisen oder als erster Komparator ausgebildet sein. Der erste Komparator kann durch einen oder mehrere Operationsverstärker und weitere Komponenten gebildet/realisiert werden. Die erste Vergleichskomponente kann ausgebildet sein, einen ersten Vergleichsverlauf der elektrischen Größe des ersten Halbleiterschalters mit einem Referenzwert oder Referenzwertverlauf zu ermitteln. Der Vergleichsverlauf kann beispielsweise ermittelt werden durch Vergleichen des Verlaufs der ersten Spannung mit dem Verlauf der über dem Referenzwiderstand abfallenden Referenzspannung. Dies gilt unabhängig davon, ob der Referenzwiderstand Teil eines oder des Referenzspannungsteilers ist oder nicht. Die Referenzspannung kann weitestgehend konstant sein.

Die Ermittlungseinheit weist eine zweite Vergleichskomponente auf. Die zweite Vergleichskomponente ist dazu ausgebildet, einen zweiten Vergleichsverlauf zu ermitteln durch Vergleichen des Verlaufs der zweiten Spannung mit dem Verlauf der über dem Referenzwiderstand abfallenden Referenzspannung. Die zweite Vergleichskomponente kann einen zweiten Komparator aufweisen oder als zweiter Komparator ausgebildet sein. Der zweite Komparator kann durch einen oder mehrere Operationsverstärker und weitere Komponenten gebildet/realisiert werden. Die zweite Vergleichskomponente kann ausgebildet sein, einen zweiten Vergleichsverlauf der elektrischen Größe des zweiten Halbleiterschalters mit einem Referenzwert oder Referenzwertverlauf zu ermitteln. Der Vergleichsverlauf kann beispielsweise ermittelt werden durch Vergleichen des Verlaufs der zweiten Spannung mit dem Verlauf der über dem Referenzwiderstand abfallenden Referenzspannung. Die Referenzspannung kann weitestgehend konstant sein.

Die Ermittlungseinheit kann eine erste Verknüpfungskomponente aufweisen. Die erste Verknüpfungskomponente kann ausgebildet sein, ein erstes Verknüpfungssignal durch Verknüpfen des ersten Vergleichsverlaufs mit dem ersten Ansteuersignal zu ermitteln. Die erste Verknüpfungskomponente kann ein Exklusiv-Oder-Gatter (XOR-Gatter) aufweisen oder als XOR-Gatter ausgebildet sein.

Die Ermittlungseinheit kann eine zweite Verknüpfungskomponente aufweisen. Die zweite Verknüpfungskomponente kann ausgebildet sein, ein zweites Verknüpfungssignal durch Verknüpfen des zweiten Vergleichsverlaufs mit dem zweiten Ansteuersignal zu ermitteln. Die zweite Verknüpfungskomponente kann beispielsweise ein XOR-Gatter aufweisen oder als XOR-Gatter ausgebildet sein.

Die Ermittlungseinheit kann ferner eine dritte Verknüpfungskomponente aufweisen.

Die dritte Verknüpfungskomponente kann ausgebildet sein, ein Ausgangssignal durch Verknüpfen des ersten Verknüpfungssignals mit dem zweiten Verknüpfungssignal zu ermitteln. Die dritte Verknüpfungskomponente kann ein ODER-Gatter (auch als OR-Gatter bezeichnet) aufweisen oder als ODER-Gatter ausgebildet sein.

Das System kann ferner ein zeitliches Verzögerungsglied, hierin auch kurz als Verzögerungsglied bezeichnet, aufweisen. Das Verzögerungsglied kann ausgebildet sein, ein Fehlersignal durch Anwenden einer Einschaltverzögerung zu ermitteln. Das Verzögerungsglied kann ausgebildet sein, ein Fehlersignal durch Kombination des Ausgangssignals mit einer Einschaltverzögerung zu ermitteln. Mit Hilfe des Verzögerungsglieds können durch Signallaufzeiten und Schaltverzögerungen verursachte Fehldiagnosen zumindest reduziert, wenn nicht sogar völlig verhindert werden.

Das System kann einen Phasengenerator aufweisen. Der Phasengenerator kann ausgebildet sein, das erste Ansteuersignal beispielsweise aus einem Taktsignal zu erzeugen. Zusätzlich oder alternativ kann der Phasengenerator ausgebildet sein, das zweite Ansteuersignal beispielsweise aus dem Taktsignal zu erzeugen. Dadurch kann der Phasengenerator dazu ausgebildet sein, die vorhandenen Halbleiterschalter abwechselnd einzuschalten.

Auch wenn hierin von einem ersten und einem zweiten Halbleiterschalter gesprochen wird, so ist die Erfindung nicht auf die Erkennung eines nicht schaltenden Halbleiterschalters von genau zwei parallel geschalteten Halbleiterschaltern begrenzt. Beispielsweise können auch drei oder mehr als drei Halbleiterschalter parallel geschaltet sein. Anders ausgedrückt kann ein System zum Erkennen eines nicht schaltenden Halbleiterschalters von mindestens zwei parallel geschalteten Halbleiterschaltern bereitgestellt werden. Beispielsweise können der erste Halbleiterschalter, der zweite Halbleiterschalter und mindestens ein dritter Halbleiterschalter zueinander parallel geschaltet sein. In diesem Fall kann das System einen nicht schaltenden Halbleiterschalter aus dem ersten Halbleiterschalter, dem zweiten Halbleiterschalter und dem mindestens einen dritten Halbleiterschalter erkennen. Falls der erste und/oder zweite Halbleiterschalter sich nicht mehr von einem offenen in einen geschlossenen Zustand überführen ließe, kann mittels des mindestens einen dritten Halbleiterschalters eine Art Notlaufbetrieb gewährleistet werden. Ohne den mindestens einen dritten Halbleiterschalter würde in dem vorgenannten Fall eine Last zumindest kurzzeitig abschalten.

Sind das erste Halbleiterbauelement und das zweite Halbleiterbauelement jeweils als Halbleiterschalter ausgebildet und bilden demnach jeweils ein Halbleiterschalter-Paar, so ist, auch wenn hierin von einem ersten und einem zweiten Halbleiterschalter-Paar gesprochen wird, die Erfindung nicht auf die Erkennung eines nicht schaltenden Halbleiterschalters eines Halbleiterschalter-Paars oder eines Halbleiterschalter-Paars von genau zwei parallel geschalteten Halbleiterschalter-Paaren begrenzt. Beispielsweise können auch drei oder mehr als drei Halbleiterschalter-Paare parallel geschaltet sein. Anders ausgedrückt kann ein System zum Erkennen eines nicht schaltenden Halbleiterschalters oder Halbleiterschalter-Paars von mindestens zwei parallel geschalteten Halbleiterschalter-Paaren bereitgestellt werden. Beispielsweise können das erste Halbleiterschalter-Paar, das zweite Halbleiterschalter-Paar und mindestens ein drittes Halbleiterschalter-Paar zueinander parallel geschaltet sein. In diesem Fall kann das System einen nicht schaltenden Halbleiter oder ein nicht schaltendes Halbleiterschalter-Paar aus dem ersten Halbleiterschalter-Paar, dem zweiten Halbleiterschalter-Paar und dem mindestens einen dritten Halbleiterschalter-Paar erkennen. Falls das erste und/oder zweite Halbleiterschalter-Paar sich nicht mehr von einem offenen in einen geschlossenen Zustand überführen ließe, kann mittels des mindestens einen dritten Halbleiterschalter-Paars eine Art Notlaufbetrieb gewährleistet werden. Ohne das mindestens eine dritte Halbleiterschalter-Paar würde in dem vorgenannten Fall eine Last zumindest kurzzeitig abschalten.

Das System kann Teil eines Leistungsverteilungssystems, wie z.B. eines Leistungsverteilungssystems mit hohen Anforderungen an die funktionale Sicherheit und/oder Zuverlässigkeit, sein. Bei Leistungsverteilungssystemen im Allgemeinen und bei solchen mit hohen Sicherheitsanforderungen im Speziellen ist es wichtig, die Funktionsfähigkeit der verwendeten Halbleiterschalter erkennen und/oder verifizieren zu können, insbesondere ohne dabei eine Last, die bevorzugt nach einem Halbleiterschalter geschaltet ist, im laufenden Betrieb zu beeinträchtigen.

Der erste Halbleiterschalter kann als Leistungshalbleiter/Leistungshalbleiterschalter ausgebildet sein. Zusätzlich oder alternativ kann der zweite Halbleiterschalter als Leistungshalbleiter/Leistungshalbleiterschalter ausgebildet sein. Beispielsweise können alle Halbleiterschalter der vorhandenen, parallel geschalteten Halbleiterschalter-Paare als Leistungshalbleiter/Leistungshalbleiterschalter ausgebildet sein. Das System kann in einen Leistungsverteiler eines Gesamtsystems eingebettet sein, wie z.B. Teil eines Leistungsverteilers eines Gesamtsystems sein. Das Gesamtsystem kann mindestens eine Spannungsquelle zur Stromversorgung (Leistungsversorgung) und mindestens einen Verbraucher aufweisen. Der Leistungsverteiler kann sich zwischen der mindestens einen Spannungsquelle und dem mindestens einen Verbraucher befinden. Der Leistungsverteiler kann den von der mindestens einen Spannungsquelle bereitgestellten Strom auf den mindestens einen Verbraucher verteilen. Der erste Halbleiterschalter und/oder der zweite Halbleiterschalter können in dem Leistungsverteiler angeordnet sein, um den mindestens einen Verbraucher anzuschalten (der mindestens einen Spannungsquelle zuzuschalten) oder abzuschalten (von der mindestens einen Spannungsquelle zu trennen). Sowohl eingangsseitig als auch ausgangsseitig des Leistungsverteilers können mindestens eine Spannungsquelle und/oder mindestens ein Verbraucher angeordnet sein.

Die paarweise antiserielle Anordnung der Halbleiterschalter, d.h. die Bildung von Halbleiterschalter-Paaren, hat den Vorteil eines bidirektionalen Betriebs. So kann das System beispielsweise zwei Spannungsquellen, z.B. eingangs- und ausgangsseitig jeweils eine Spannungsquelle, aufweisen. Ferner kann das System zwei Verbraucher, z.B. eingangs- und ausgangsseitig jeweils einen Verbraucher, aufweisen. Der erste Halbleiterschalter des ersten Halbleiterschalter-Paares kann beispielsweise angeordnet sein, einen ersten Verbraucher anzuschalten (der Spannungsquelle zuzuschalten) oder abzuschalten (von der Spannungsquelle zu trennen). Der weitere Halbleiterschalter des ersten Halbleiterschalter-Paares kann beispielsweise angeordnet sein, einen weiteren Verbraucher anzuschalten (der Spannungsquelle zuzuschalten) oder abzuschalten (von der Spannungsquelle zu trennen). Das zweite Halbleiterschalter-Paar kann entsprechend funktionieren und Redundanz für das System bereitstellen. Der erste Halbleiterschalter kann als Feldeffekttransistor ausgebildet sein. Das erste Halbleiterbauelement kann als Diode oder als Feldeffekttransistor ausgebildet sein. Der zweite Halbleiterschalter kann als Feldeffekttransistor ausgebildet sein. Das zweite Halbleiterbauelement kann als Diode oder als Feldeffekttransistor ausgebildet sein.

Gemäß einem zweiten Aspekt der Erfindung entsprechend Anspruch 9 wird ein Verfahren zum Erkennen eines nicht schaltenden Halbleiterschalters bereitgestellt. Das Verfahren umfasst ein Ansteuern eines ersten Halbleiterschalters mittels eines ersten Ansteuersignals. Das Verfahren umfasst ferner ein Ansteuern eines zweiten, zu dem ersten Halbleiterschalter parallel geschalteten Halbleiterschalters mittels eines zweiten Ansteuersignals. Das Verfahren umfasst ferner ein Erkennen, basierend auf einem Verlauf einer ersten, über einem ersten Widerstand abfallenden Spannung, ob der erste Halbleiterschalter nicht schaltet. Ein Ende des ersten Widerstands ist zwischen den ersten Halbleiterschalter und ein erstes Halbleiterbauelement geschaltet. Ein anderes Ende des ersten Widerstands ist mit einem Bezugspotential, beispielsweise mit Masse, verbunden. Das erste Halbleiterbauelement ist ausgebildet und angeordnet, einen Stromfluss durch das erste Halbleiterbauelement zumindest in eine Richtung zu verhindern. Das Verfahren umfasst ein Erkennen, basierend auf einem Verlauf einer zweiten, über einem zweiten Widerstand abfallenden Spannung, ob der zweite Halbleiterschalter nicht schaltet. Ein Ende des zweiten Widerstands ist zwischen den zweiten Halbleiterschalter und ein zweites Halbleiterbauelement geschaltet. Ein anderes Ende des zweiten Widerstands ist mit dem Bezugspotential, beispielsweise mit Masse, verbunden. Das zweite Halbleiterbauelement ist ausgebildet und angeordnet, einen Stromfluss durch das zweite Halbleiterbauelement zumindest in eine Richtung zu verhindern.

Auch wenn einige der voranstehend beschriebenen Aspekte in Bezug auf das System beschrieben wurden, so können diese Aspekte auch in entsprechender Weise in dem Verfahren realisiert sein/werden.

Die vorliegende Offenbarung soll weiter anhand von Figuren erläutert werden. Diese Figuren zeigen schematisch:

Figur 1            ein Gesamtsystem mit Stromversorgung, Leistungsverteiler und elektrischem Verbraucher;

Figur 2            eine mögliche Ausgestaltung eines Leistungsverteilers aus Figur 1;

Figur 3a           eine mögliche Ausgestaltung eines, in dem Leistungsverteiler aus Figur 2 anwendbaren Schaltsystems gemäß einem Ausführungsbeispiel;

Figur 3b           eine mögliche Ausgestaltung eines, in dem Leistungsverteiler aus Figur 2 anwendbaren Schaltsystems gemäß einem Ausführungsbeispiel; und

Figuren 4a, b     beispielhafte Signalverläufe elektrischer Größen für die Verwendung in dem System aus Figur 3a oder 3b.

Im Folgenden werden, ohne hierauf beschränkt zu sein, spezifische Details dargelegt, um ein vollständiges Verständnis der vorliegenden Offenbarung zu liefern. Es ist einem Fachmann jedoch klar, dass die vorliegende Offenbarung in anderen Ausführungsbeispielen verwendet werden kann, die von den nachfolgend dargelegten Details abweichen können. Beispielsweise werden im Folgenden spezifische Konfigurationen und Ausgestaltungen eines Systems beschrieben, die nicht als einschränkend anzusehen sind.

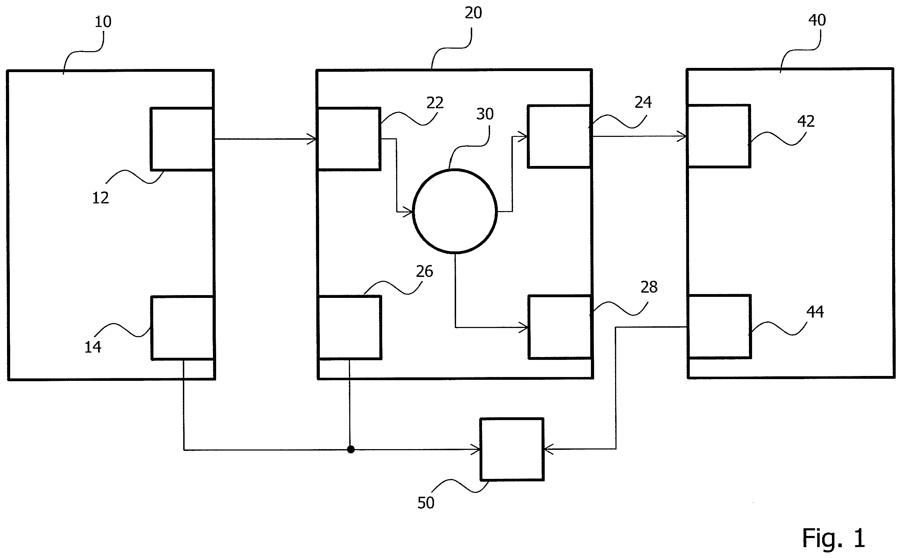

Figur 1 zeigt schematisch ein Leistungsverteilungssystem mit einer Spannungsquelle als Stromversorgung 10, einem Leistungsverteiler 20 und einem elektrischen Verbraucher 40. Die Spannungsquelle 10 weist einen positiven Anschluss 12 und einen negativen Anschluss 14 auf. Der Leistungsverteiler 20 weist eingangsseitig einen positiven Anschluss 22 und einen negativen Anschluss 26 auf. Ferner weist der Leistungsverteiler 20 ausgangsseitig einen positiven Anschluss 24 auf. Der Leistungsverteiler 20 weist ein Schaltsystem 30 auf, mit dem der Verbraucher 40 an- und abgeschaltet werden kann. Das Schaltsystem 30 weist eine Steuerung 28 auf. Bei der Steuerung 28 kann es sich um eine übergeordnete Steuerung handeln. Der elektrische Verbraucher 40 weist einen positiven Anschluss 42 und einen negativen Anschluss 44 auf.

Der negative Anschluss 14 der Spannungsquelle 10, der negative Anschluss 26 des Leistungsverteilers 20 und der negative Anschluss 44 des Verbrauchers 40 sind jeweils mit Erde/Masse 50 verbunden. Dadurch haben die Spannungsquelle 10, der Leistungsverteiler 20 und der Verbraucher 40 das gleiche Bezugspotential, im vorliegenden Fall beispielhaft Masse/Erde 50.

Die Spannungsquelle 10 ist über ihren positiven Anschluss 12 mit dem eingangsseitigen positiven Anschluss 22 des Leistungsverteilers 20 verbunden. Zusätzlich oder alternativ kann eine Spannungsquelle als Stromversorgung ausgangsseitig mit dem Leistungsverteiler 10 verbunden sein. Der Leistungsverteiler 20 ist ausgangsseitig über seinen ausgangsseitigen positiven Anschluss 24 mit dem elektrischen Verbraucher 40 verbunden. Auch wenn beispielhaft nur ein Verbraucher 40 gezeigt ist, so können mehrere elektrische Verbraucher 40 mit dem Leistungsverteiler 20 verbunden sein, beispielsweise über weitere, in Figur 1 nicht dargestellte ausgangsseitige positive Anschlüsse des Leistungsverteilers 20. Zusätzlich oder alternativ können auch eingangsseitig ein oder mehrere Verbraucher mit dem Leistungsverteiler 20 verbunden sein. Das Schaltsystem 30 ist ausgebildet, den elektrischen Verbraucher 40 an- und abzuschalten. Im Fall mehrerer elektrischer Verbraucher ist das System entsprechend ausgebildet, mehrere elektrische Verbraucher jeweils an- und abzuschalten. Ist ein Abschalten nicht möglich, gibt das Schaltsystem 30 eine entsprechende Fehlermeldung an die Steuerung 28. Insbesondere kann es sich bei dem Leistungsverteilungssystem um ein Leistungsverteilungssystem mit hohen Sicherheitsanforderungen (und/oder Zuverlässigkeitsanforderungen) handeln. Bei diesen Systemen ist es umso wichtiger, die Funktionsfähigkeit der verwendeten Schalter (zum An- und Abschalten des Verbrauchers 40) verifizieren zu können.

Sind sowohl eingangs- als auch ausgangsseitig eine Spannungsquelle als Stromversorgung sowie ein oder mehrere Verbraucher angeordnet, so ist es vorteilhaft, wenn der Leistungsverteiler 20 bidirektional arbeiten kann.

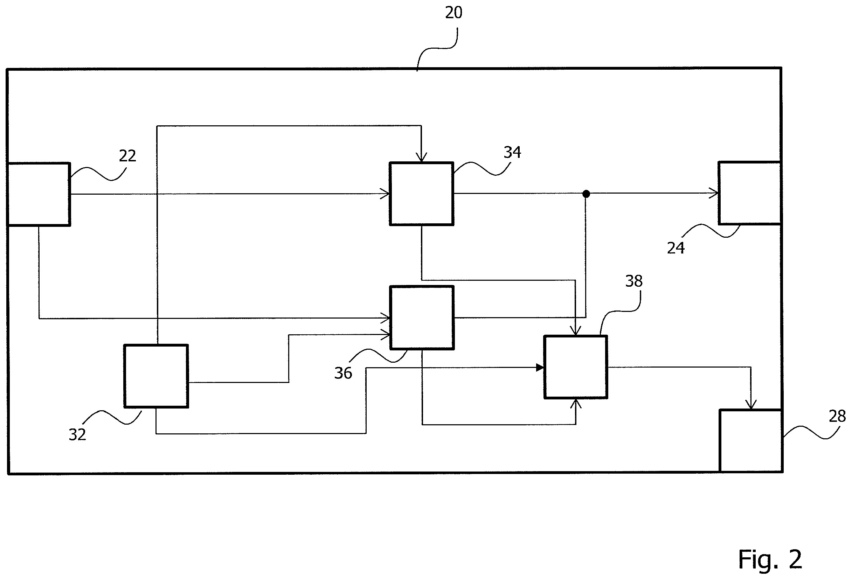

Figur 2 zeigt eine beispielhafte Ausgestaltung eines Leistungsverteilers 20 aus Figur 1. Der Leistungsverteiler 20 weist eingangsseitig einen positiven Anschluss 22 auf. Ferner weist der Leistungsverteiler 20 ausgangsseitig einen positiven Anschluss 24 auf. Ferner weist der Leistungsverteiler eine Steuerung 28 auf. Der negative Anschluss des Leistungsverteilers aus Figur 1 ist der Einfachheit halber in Figur 2 nicht dargestellt. In Figur 2 ist eine beispielhafte Ausgestaltung des Schaltsystems 30 aus Figur 1 gezeigt. Gemäß diesem Beispiel weist das Schaltsystem 30 einen Phasengenerator 32, ein erstes Halbleiterschalter-Paar 34, ein zweites Halbleiterschalter-Paar 36 und eine Ermittlungseinheit 38 auf, die beispielsweise zwei Komparatoren aufweisen kann. Das erste Halbleiterschalter-Paar 34 und das zweite Halbleiterschalter-Paar 36 dienen dazu, den elektrischen Verbraucher 40 an- und abzuschalten. Insbesondere die Abschaltfunktionalität sollte auf ihre Zuverlässigkeit überwacht werden. Das erste Halbleiterschalter-Paar 34 und der zweite Halbleiterschalter 36 sind parallel zueinander geschaltet.

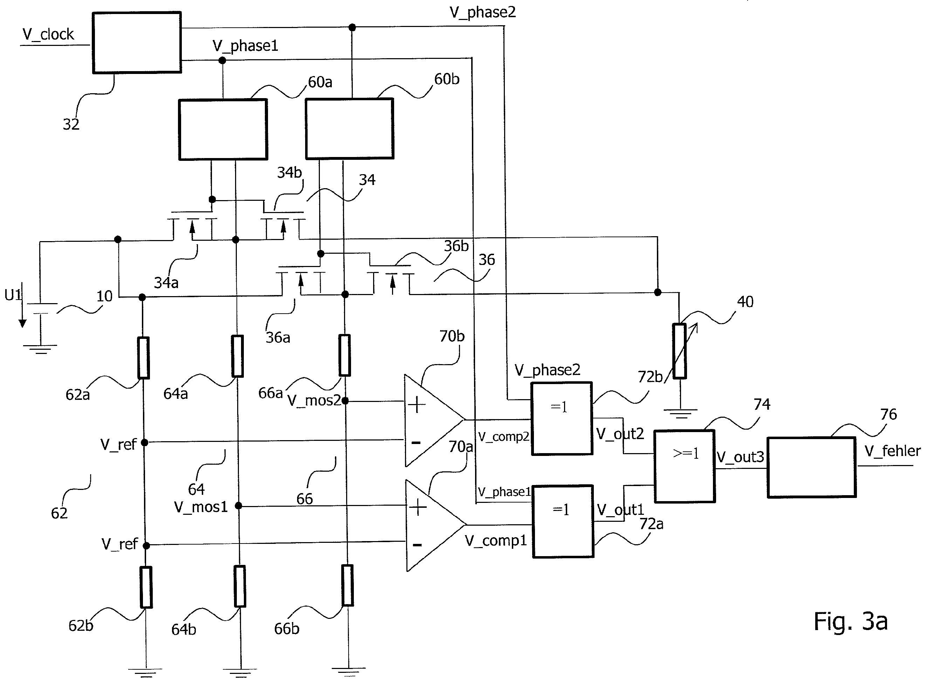

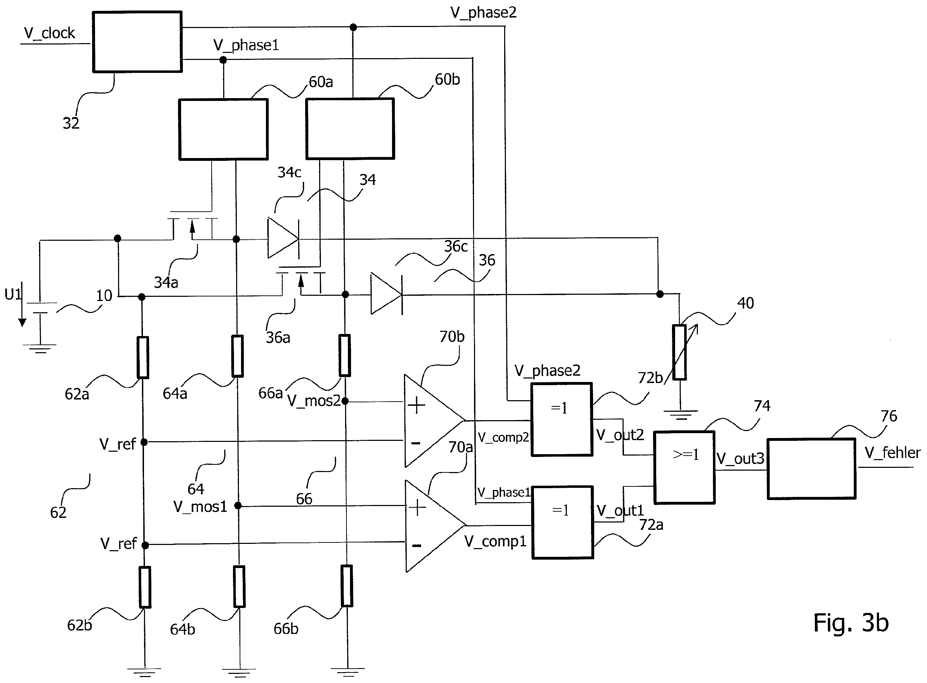

Der Phasengenerator 32 steuert das erste Halbleiterschalter-Paar 34 und das zweite Halbleiterschalter-Paar 36, z.B. jeweils mit Hilfe eines erzeugten Ansteuersignals, an. Das erste Halbleiterschalter-Paar 34 wird mit einem ersten Ansteuersignal angesteuert. Das zweite Halbleiterschalter-Paar 36 wird mit einem zweiten Ansteuersignal angesteuert. Wie später in Bezug auf Figuren 3a und 3b genauer erläutert, wird ein Verlauf einer ersten Spannung ermittelt, die über einem Widerstand abfällt, der mit dem ersten Halbleiterschalter-Paar 34 verschaltet ist. Ferner wird ein Verlauf einer zweiten Spannung ermittelt, die über einem Widerstand abfällt, der mit dem zweiten Halbleiterschalter-Paar 36 verschaltet ist.

Die Ermittlungseinheit 38 kann, basierend auf dem Verlauf der ersten Spannung, die über dem mit dem ersten Halbleiterschalter-Paar 34 verschalteten Widerstand abfällt, einen Fehler beim Schalten des ersten Halbleiterschalter-Paars 34 erkennen. Die Ermittlungseinheit 38 kann, basierend auf dem Verlauf der zweiten Spannung, die über dem mit dem zweiten Halbleiterschalter-Paar 36 verschalteten Widerstand abfällt, einen Fehler beim Schalten des zweiten Halbleiterschalter-Paars 36 erkennen. Beispielsweise können die erfassten Spannungen in der Ermittlungseinheit 38 jeweils mit einem Referenzspannungswert verglichen werden. Die Ermittlungseinheit 38 kann aus den Spannungen jeweils ein Ausgangssignal erzeugen. Aus diesem Ausgangssignal lässt sich ableiten, ob das erste Halbleiterschalter-Paar 34 und/oder das zweite Halbleiterschalter-Paar 36 tatsächlich wie vorgesehen schaltet/schalten oder nicht, insbesondere wie vorgesehen abschaltet/abschalten oder abschaltbar ist/sind. Wird ein Fehler beim Schalten, insbesondere beim Abschalten, festgestellt, wird beispielsweise die Steuerung 28 hierüber informiert. Die Steuerung 28 kann beispielsweise als übergeordnete Instanz entsprechende Maßnahmen treffen, wie z.B. selbst den elektrischen Verbraucher 40 abschalten oder vom Leistungsverteiler 20 trennen oder in einen sicheren Zustand überführen.

Figur 3a zeigt eine spezifische Ausgestaltung, genauer gesagt eine mögliche Schaltung als Hardware-Realisierung, des Schaltsystems 30. Das Schaltsystem 30 weist einen Phasengenerator 32 auf. Der Phasengenerator 32 ist ausgebildet, aus einem Taktsignal ein erstes Ansteuersignal V_phase1 und ein zweites Ansteuersignal V_phase2 zu erzeugen. Das erste Ansteuersignal V_phase1 wird in einen ersten Gate-Treiber 60a eingegeben. Das zweite Ansteuersignal V_phase2 wird in einen zweiten Gate-Treiber 60b eingegeben. Der erste Gate-Treiber 60a ist mit dem Gate-Anschluss eines ersten Halbleiterschalter-Paars 34 verbunden. Das erste Halbleiterschalter-Paar 34 weist zwei Halbleiterschalter auf, nämlich einen Halbleiterschalter 34a und, als ein Beispiel für ein Halbleiterbauelement, einen Halbleiterschalter 34b, die beide in dem Beispiel aus Figur 3a als MOSFET ausgebildet sind und im Folgenden demnach als MOSFET 34a und MOSFET 34b bezeichnet werden. Demgemäß wird das Halbleiterschalter-Paar 34 in Bezug auf Figur 3a beispielhaft als erstes MOSFET-Paar 34 bezeichnet. Der zweite Gate-Treiber 60b ist mit dem Gate-Anschluss eines zweiten Halbleiterschalter-Paars 36 verbunden. Das zweite Halbleiterschalter-Paar 36 weist zwei Halbleiterschalter auf, nämlich einen Halbleiterschalter 36a und, als Beispiel für eine Halbleiterbauelement, einen Halbleiterschalter 36b, die beide in dem Beispiel aus Figur 3a als MOSFET ausgebildet sind und dementsprechend im Folgenden als MOSFET 36a und MOSFET 36b bezeichnet werden. Demnach wird das Halbleiterschalter-Paar 36 in Bezug auf Figur 3a beispielhaft als zweites MOSFET-Paar 36 bezeichnet.

Der Drain-Anschluss des MOSFETs 34a des ersten MOSFET-Paars 34 ist mit einer Spannungsquelle 10 verbunden, welche das Schaltsystem 30 mit Strom versorgt. Alternativ hierzu kann der Drain-Anschluss des MOSFETs 34a des ersten MOSFET-Paars 34 mit einer Last verbunden sein. Ferner kann zusätzlich zu der Spannungsquelle 10 eingangsseitig der Schaltung eine Last vorgesehen sein, so dass in diesem Fall der Drain-Anschluss des MOSFETs 34a des ersten MOSFET-Paars 34 mit der Spannungsquelle 10 und einer Last verbunden wäre.

Mit dem MOSFET 34a des ersten MOSFET-Paars 34 ist antiseriell ein MOSFET 34b des ersten MOSFET-Paars 34 verschaltet. Antiseriell bedeutet in diesem speziellen Fall von MOSFETs, dass die beiden MOSFET 34a, 34b zwar in Reihe geschaltet sind, aber die Source-Anschlüsse der beiden MOSFETS 34a, 34b miteinander verbunden sind. Dadurch unterscheiden sich die beiden MOSFETs 34a, 34b in ihrer Sperrrichtung, d.h. in der Richtung, in der sie sperren. Auch wenn in den Figuren nicht erkennbar, können die MOSFETs 34a, 34b jeweils eine sogenannte parasitäre Bulk-Diode, parallel zum schaltbaren Kanal, in sich haben / aufweisen, die technologisch bedingt sein kann. Diese Bulk-Diode verhindert, dass der jeweilige MOSFET 34a, 34b in Durchlassrichtung der Bulk-Diode sperren kann. Deshalb gewährleistet das MOSFET-Paar 34 ein Sperren in beide Richtungen. Anders ausgedrückt, ermöglicht das Vorhandensein des MOSFET-Paars 34 (mit den zwei antiseriellen MOSFETS 34a, 34b) im Gegensatz zu nur einem MOSFET, in beide Richtungen sperren zu können.

Demgemäß ist der Source-Anschluss des MOSFETs 34a des ersten MOSFET-Paars 34 mit dem Source-Anschluss des MOSFETs 34b des ersten MOSFET-Paars 34 verbunden. Der Drain-Anschluss des MOSFETs 34b des ersten MOSFET-Paars 34 ist über einen variablen Widerstand, welcher die Last 40 aus Figur 1 in der Schaltung aus Figur 3a illustriert und dementsprechend ebenfalls mit dem Bezugszeichen 40 bezeichnet wird, mit Masse/Erde als Bezugspotential verbunden. Das heißt, in Figur 3a ist der Drain-Anschluss des MOSFETs 34b des ersten MOSFET-Paars 34 mit der Last 40 verbunden. Alternativ hierzu kann der Drain-Anschluss des MOSFETs 34b des ersten MOSFET-Paars 34 mit einer Spannungsquelle verbunden sein. Ferner kann zusätzlich zu der Last 40 ausgangsseitig der Schaltung eine Spannungsquelle vorgesehen sein, so dass in diesem Fall der Drain-Anschluss des MOSFETs 34b des ersten MOSFET-Paars 34 mit der Last 40 und einer Spannungsquelle verbunden wäre. Insbesondere in Schaltsystemen für Automotive-Anordnungen sind oftmals aus Redundanzgründen eingangsseitig und ausgangsseitig, d.h. beidseitig, sowohl eine Spannungsquelle als auch eine Last vorgesehen.

Der Drain-Anschluss des MOSFETs 36a des zweiten MOSFET-Paars 36 ist mit der Spannungsquelle 10 verbunden. Alternativ hierzu kann der Drain-Anschluss des MOSFETs 36a des zweiten MOSFET-Paars 36 mit einer Last verbunden sein. Ferner kann zusätzlich zu der Spannungsquelle 10 eingangsseitig der Schaltung eine Last vorgesehen sein, so dass in diesem Fall der Drain-Anschluss des MOSFETs 36a des zweiten MOSFET-Paars 36 mit der Spannungsquelle 10 und einer Last verbunden wäre.

Mit dem MOSFET 36a des zweiten MOSFET-Paars 36 ist antiseriell ein MOSFET 36b des zweiten MOSFET-Paars 36 verschaltet. Antiseriell bedeutet auch hier, dass die beiden MOSFETs 36a, 36b zwar in Reihe geschaltet sind, aber die Source-Anschlüsse der beiden MOSFETS 36a, 36b miteinander verbunden sind. Die antiserielle Verschaltung der MOSFETS 36a, 36b zu einem MOSFET-Paar 36 gewährleistet, aufgrund der jeweiligen parasitären Bulk-Diode, auch in diesem Fall ein Sperren in beide Richtungen. Anders ausgedrückt, ermöglicht das Vorhandensein des MOSFET-Paars 36 (mit den zwei antiseriellen MOSFETS 36a, 36b) im Gegensatz zu nur einem MOSFET, in beide Richtungen sperren zu können.

Demgemäß ist der Source-Anschluss des MOSFETs 36a des zweiten MOSFET-Paars 36 mit dem Source-Anschluss des MOSFETs 36b des zweiten MOSFET-Paars 36 verbunden. Der Drain-Anschluss des MOSFETs 36b des zweiten MOSFET-Paars 36 ist über die Last 40 (auch als Verbraucher 40 bezeichnet) mit Masse/Erde als Bezugspotential verbunden. Das heißt, in Figur 3a ist der Drain-Anschluss des MOSFETs 36b des zweiten MOSFET-Paars 36 mit der Last 40 verbunden. Alternativ hierzu kann der Drain-Anschluss des MOSFETs 36a des zweiten MOSFET-Paars 36 mit einer Spannungsquelle verbunden sein. Ferner kann zusätzlich zu der Last 40 ausgangsseitig der Schaltung eine Spannungsquelle vorgesehen sein, so dass in diesem Fall der Drain-Anschluss des MOSFETs 36b des zweiten MOSFET-Paars 36 mit der Last 40 und einer Spannungsquelle verbunden sein kann.

Ferner sind in Figur 3a drei Spannungsteilerschaltungen 62, 64, 66 gezeigt, die im Folgenden kurz als Spannungsteiler 62, 64, 66 bezeichnet werden. Der Spannungsteiler 62 kann auch als Referenzspannungsteiler 62 bezeichnet werden und weist in dem Beispiel aus Figur 3a genau zwei Referenzwiderstände 62a, 62b auf. Der Spannungsteiler 64 weist in dem Beispiel aus Figur 3a genau zwei Widerstände 64a, 64b auf. Ein Ende des Spannungsteilers 64 ist zwischen die beiden MOSFET 34a, 34b des ersten MOSFET-Paars 34 geschaltet oder, anders ausgedrückt, mit einer Verbindung der Source-Anschlüsse der MOSFET 34a, 34b des ersten MOSFET-Paars 34 verbunden. Ein anderes Ende des Spannungsteilers 64 ist mit Masse als Bezugspotential verbunden. Der Spannungsteiler 66 weist in dem Beispiel aus Figur 3a genau zwei Widerstände 66a, 66b auf. Ein Ende des Spannungsteilers 66 ist zwischen die beiden MOSFET 36a, 36b des zweiten MOSFET-Paars 36 geschaltet oder, anders ausgedrückt, mit einer Verbindung der Source-Anschlüsse der MOSFET 36a, 36b des zweiten MOSFET-Paars 36 verbunden. Ein anderes Ende des Spannungsteilers 66 ist mit Masse als Bezugspotential verbunden.

Die Spannungsteiler 62, 64, 66 können als Teil einer spezifischen Realisierung der Ermittlungseinheit 38 (z.B. aus Figur 2) angesehen werden. Über dem Spannungsteiler 62 fällt stets eine Spannung ab, deren Wert dem Wert der Spannung U1 der Spannungsquelle 10 entspricht. Demnach ist die über dem Spannungsteiler 62 abfallende Spannung bekannt. Aus dem Verhältnis der Widerstandswerte der Widerstände 62a, 62b ist die jeweils über den Widerständen 62a, 62b abfallende Spannung bekannt. Sind beispielsweise die Widerstandswerte der Widerstände 62a, 62b gleich groß, fällt jeweils eine gleich große Spannung über den Widerständen 62a, 62b ab, genauer gesagt jeweils die Hälfte der Spannung der Spannungsquelle 10. Allgemein ergibt sich für die über dem Widerstand 62b abfallende Spannung folgende bekannte Spannungsteiler-Formel:

$$U\_wid62b = U1 * R\_wid62b / (R\_wid62a + R\_wid62b),$$

wobei U_wid62b die über dem Widerstand 62b abfallende Spannung, U1 die Spannung der Spannungsquelle 10, R_wid62a den Widerstandswert des Widerstands 62a und R_wid62b den Widerstandswert des Widerstands 62b bezeichnen.

Über dem Spannungsteiler 64 fällt eine unterschiedliche Spannung ab, je nachdem, ob die MOSFETs 34a, 34b des ersten MOSFET-Paars 34 geschlossen oder offen sind. Sind die MOSFETs 34a, 34b des ersten MOSFET-Paars 34 in einem geschlossenen Zustand, fällt an dem Spannungsteiler 64 eine Spannung ab, deren Wert dem Wert der Spannung der Spannungsquelle 10 entspricht. Aus dem Verhältnis der Widerstandswerte der Widerstände 64a, 64b ergibt sich die jeweils über den Widerständen 64a, 64b abfallende Spannung. Sind beispielsweise die Widerstandswerte der Widerstände 64a, 64b gleich groß, fällt jeweils eine gleich große Spannung über den Widerständen 64a, 64b ab, genauer gesagt, im Fall geschlossener MOSFETs 34a, 34b des ersten MOSFET-Paars 34 jeweils die Hälfte der Spannung U1 der Spannungsquelle 10. Sind die MOSFETs 34a, 34b des ersten MOSFET-Paars 34 in einem offenen Zustand, fällt über dem MOSFET 34a des ersten MOSFET-Paars 34 eine relativ hohe Spannung ab und somit an dem Spannungsteiler 64 eine deutlich geringere Spannung ab, als im Fall eines geschlossenen MOSFETs 34a. Der Spannungsabfall über dem Spannungsteiler 64 kann, im Fall eines offenen MOSFETs 34a, sogar gegen 0V gehen oder 0V betragen. Aus dem Verhältnis der Widerstandswerte der Widerstände 64a, 64b ergibt sich die jeweils über den Widerständen 64a, 64b abfallende Spannung, die dann ebenfalls sehr gering ist oder sogar zumindest nahezu 0V beträgt. Sind beispielsweise die Widerstandswerte der Widerstände 64a, 64b gleich groß, fällt jeweils eine gleich große, aber sehr geringe Spannung über den Widerständen 64a, 64b ab, genauer gesagt, im Fall eines offenen MOSFETs 34a, 34b des ersten MOSFET-Paars 34 jeweils eine sehr geringe Spannung von beispielsweise zumindest nahezu 0V.

Über dem Spannungsteiler 66 fällt eine unterschiedliche Spannung ab, je nachdem, ob die MOSFETs 36a, 36b des zweiten MOSFET-Paars 36 geschlossen oder offen sind. Sind die MOSFETs 36a, 36b des zweiten MOSFET-Paars 36 in einem geschlossenen Zustand, fällt an dem Spannungsteiler 66 eine Spannung ab, deren Wert dem Wert der Spannung der Spannungsquelle 10 entspricht. Aus dem Verhältnis der Widerstandswerte der Widerstände 66a, 66b ergibt sich die jeweils über den Widerständen 66a, 66b abfallende Spannung. Sind beispielsweise die Widerstandswerte der Widerstände 66a, 66b gleich groß, fällt jeweils eine gleich große Spannung über den Widerständen 66a, 66b ab, genauer gesagt, im Fall geschlossener MOSFETs 36a, 36b des zweiten MOSFET-Paars 36 jeweils die Hälfte der Spannung U1 der Spannungsquelle 10. Sind die MOSFETs 36a, 36b des zweiten MOSFET-Paars 36 in einem offenen Zustand, fällt über dem MOSFET 36a des zweiten MOSFET-Paars 36 eine relativ hohe Spannung ab und somit an dem Spannungsteiler 66 eine deutlich geringere Spannung ab, als im Fall eines geschlossenen MOSFETs 36a. Der Spannungsabfall über dem Spannungsteiler 66 kann, im Fall eines offenen MOSFETs 36a, sogar gegen 0V gehen oder 0V betragen. Aus dem Verhältnis der Widerstandswerte der Widerstände 66a, 66b ergibt sich die jeweils über den Widerständen 66a, 66b abfallende Spannung, die dann ebenfalls sehr gering ist oder sogar zumindest nahezu 0V beträgt. Sind beispielsweise die Widerstandswerte der Widerstände 66a, 66b gleich groß, fällt jeweils eine gleich große, aber sehr geringe Spannung über den Widerständen 66a, 66b ab, genauer gesagt, im Fall eines offenen MOSFETs 36a, 36b des zweiten MOSFET-Paars 36 jeweils eine sehr geringe Spannung von beispielsweise zumindest nahezu 0V.

Die über den auf Masse geschalteten Widerständen 62b, 64b, 66b der drei Spannungsteiler 62, 64, 66 abfallenden Spannungswerte werden in zwei Komparatoren 70a, 70b eingegeben. Genauer gesagt wird die über dem Referenzwiderstand 62b abfallende Referenzspannung V_ref in den negativen (invertierenden) Eingang eines ersten Komparators 70a und in den negativen (invertierenden) Eingang eines zweiten Komparators 70b eingegeben. Ferner wird die über dem Widerstand 64b des Spannungsteilers 64 abfallende Spannung V_mos1 in einen positiven (nicht-invertierenden) Eingang des ersten Komparators 70a eingegeben. Ferner wird die über dem Widerstand 66b des Spannungsteilers 66 abfallende Spannung V_mos2 in einen positiven (nicht-invertierenden) Eingang des zweiten Komparators 70b eingegeben. Sowohl der negative (invertierende) Eingang des ersten Komparators 70a als auch der negative (invertierende) Eingang des zweiten Komparators 70b werden also mit der gleichen Referenzspannung V_ref gespeist.

In dem in Figur 3a gezeigten Beispiel sind die Komparatoren 70a, 70b als nichtinvertierende Komparatoren ausgebildet. Bei einem solchen nicht-invertierenden Komparator wird die Referenzspannung, im Fall aus Figur 3a also die Referenzspannung V_ref, an den invertierenden Eingang des Komparators angeschlossen. Das Eingangssignal, hier der jeweilige Verlauf der Spannung V_mos1 über dem Widerstand 64b des Spannungsteilers 64 und der Spannung V_mos2 über dem Widerstand 66b des Spannungsteilers 66, wird jeweils an den nicht-invertierenden Eingang des Komparators angeschlossen. Bei einem nicht-invertierenden Komparator wird als Ausgang eine digitale 0 (ein LOW-Pegel) ausgegeben, wenn die Eingangsspannung kleiner ist als die Referenzspannung. Wenn die Eingangsspannung hingegen gleich groß ist wie oder größer ist als die Referenzspannung, wird eine digitale 1 (ein HIGH-Pegel) ausgegeben. Alternativ wäre es möglich, invertierende Komparatoren in Figur 3a vorzusehen. Die Komparatoren 70a, 70b können jeweils aufgebaut sein durch einen oder mehrere Operationsverstärker und/oder weitere Komponenten.

Der Ausgang des ersten Komparators 70a ist mit einem ersten XOR-Gatter 72a verbunden. Dadurch erhält das erste XOR-Gatter 72a als erste Eingangsgröße das Ausgangssignal V_comp1 des ersten Komparators 70a. Der Ausgang des zweiten Komparators 70b ist mit einem zweiten XOR-Gatter 72b verbunden. Dadurch erhält das zweite XOR-Gatter 72b als erste Eingangsgröße das Ausgangssignal V_comp2 des zweiten Komparators 70b. Das erste XOR-Gatter 72a erhält als zweite Eingangsgröße das erste Ansteuersignal V_phase1. Das zweite XOR-Gatter 72b erhält als zweite Eingangsgröße das zweite Ansteuersignal V_phase2. Das erste XOR-Gatter 72a führt demnach eine XOR-Verknüpfung von dem Ausgang des ersten Komparators 70a (Signal V_comp1) und dem ersten Ansteuersignal V_phase1 aus. Das zweite XOR-Gatter 72b führt demnach eine XOR-Verknüpfung von dem Ausgang des zweiten Komparators 70b (Signal V_comp2) und dem zweiten Ansteuersignal V_phase2 aus.

Die Ausgänge des ersten XOR-Gatters 72a (Signal V_out1) und des zweiten XOR-Gatters 72b (Signal V_out2) werden als Eingangsgrößen in ein OR-Gatter 74 eingegeben. Der Ausgang des OR-Gatters 74 ist daher eine Überlagerung der Ausgänge des ersten und des zweiten XOR-Gatters 72a, 72b. Beispielsweise aus dem Ausgangssignal des OR-Gatters (Signal V_out3) lassen sich Probleme oder Fehler beim Schalten des ersten MOSFET-Paars 34a und/oder des zweiten MOSFET-Paars 34b ableiten.

Die Erkennung eines Fehlers beim Schalten lässt sich verbessern, indem hinter das OR-Gatter 74 ein Zeitverzögerungsglied 76 geschaltet wird. Dies kann realisiert werden, indem durch die Zeitverzögerung 76 sogenannte Spikes (als Spikes können kurze Peaks, d.h. Peaks mit einer Dauer unter einem vorgegebenen zeitlichen Schwellenwert, verstanden werden) ausschließt. Das Zeitverzögerungsglied 76 führt dazu, dass nur solche Ungewöhnlichkeiten als Fehler erkannt werden, deren Dauer über einem vorgegebenen zeitlichen Schwellenwert liegt. Das aus dem Zeitverzögerungsglied 76 ausgegebene Signal kann folglich als Fehlersignal V_fehler bezeichnet werden. Anders ausgedrückt kann das Zeitverzögerungsglied 76 als Einschaltverzögerung bezeichnet werden, die dazu führt, dass nur Fehlersignale oder Peaks eines Fehlersignals über einer bestimmten Länge als gültig, d.h. als tatsächliche/gültige Fehler, bewertet werden.

Unter Bezugnahme auf Figur 3a kann die Ermittlungseinheit aus Figur 2 beispielsweise implementiert sein durch die Spannungsteiler 62, 64, 66, die Komparatoren 70a, 70b, die XOR-Gatter 72a, 72b und das OR-Gatter 74 aus Figur 3a. Alternative Realisierungen sind möglich, bei denen eine oder mehrere der vorgenannten Komponenten entfallen, ersetzt werden und/oder weitere Komponenten hinzukommen. Die Figur 3a ist somit lediglich als beispielhafte Hardware-Realisierung des Schaltsystems aus Figur 2 anzusehen.

Figur 3b zeigt eine Variante der spezifischen Ausgestaltung aus Figur 3a, genauer gesagt eine Variante einer möglichen Schaltung als Hardware-Realisierung des Schaltsystems 30 aus Figur 2. Die Variante aus Figur 3b unterscheidet sich dadurch von der Ausgestaltung aus Figur 3a, dass anstelle eines MOSFETs 34b des ersten MOSFET-Paars 34 und anstelle eines MOSFET 36b des zweiten MOSFET-Paars 36 jeweils eine Halbleiterdiode 34c, 36c verwendet wird. In dem Beispiel aus Figur 3b werden der MOSFET 34b und der MOSFET 36b jeweils durch eine Halbleiterdiode ersetzt. Alternativ könnten der MOSFET 34a und der MOSFET 36a jeweils durch eine Halbleiterdiode 34c, 36c ersetzt werden. Kombinationen sind möglich. In der Figur 3b existieren dadurch keine MOSFET-Paare wie in Figur 3a sondern vielmehr Halbleiterbauelement-Paare 34, 36. Jedes der Halbleiterbauelement-Paare 34, 36 aus Figur 3b weist einen MOSFET 34a, 36a und eine Halbleiterdiode 34b, 36b auf.

In Bezug auf die in die Komparatoren 70a, 70b eingegebenen Spannungswerte V_ref, V_mos1, V_mos2 gilt in Figur 3b Folgendes.

Über dem Spannungsteiler 62 fällt stets eine Spannung ab, deren Wert dem Wert der Spannung U1 der Spannungsquelle 10 entspricht. Demnach ist die über dem Spannungsteiler 62 abfallende Spannung bekannt. Aus dem Verhältnis der Widerstandswerte der Widerstände 62a, 62b ist die jeweils über den Widerständen 62a, 62b abfallende Spannung bekannt. Sind beispielsweise die Widerstandswerte der Widerstände 62a, 62b gleich groß, fällt jeweils eine gleich große Spannung über den Widerständen 62a, 62b ab, genauer gesagt jeweils die Hälfte der Spannung der Spannungsquelle 10.

Über dem Spannungsteiler 64 fällt eine unterschiedliche Spannung ab, je nachdem, ob der MOSFET 34a des ersten Halbleiterbauelement-Paars 34 geschlossen oder offen ist. Ist der MOSFET 34a des ersten Halbleiterbauelement-Paars 34 in einem geschlossenen Zustand, fällt an dem Spannungsteiler 64 eine Spannung ab, deren Wert dem Wert der Spannung U1 der Spannungsquelle 10 entspricht. Aus dem Verhältnis der Widerstandswerte der Widerstände 64a, 64b ergibt sich die jeweils über den Widerständen 64a, 64b abfallende Spannung. Sind beispielsweise die Widerstandswerte der Widerstände 64a, 64b gleich groß, fällt jeweils eine gleich große Spannung über den Widerständen 64a, 64b ab, genauer gesagt, im Fall eines geschlossenen MOSFETs 34a des ersten Halbleiterbauelement-Paars 34 jeweils die Hälfte der Spannung der Spannungsquelle 10. Ist der MOSFET 34a des ersten MOSFET-Paars 34 in einem offenen Zustand, fällt über dem MOSFET 34a des ersten MOSFET-Paars 34 eine relativ hohe Spannung ab und somit an dem Spannungsteiler 64 eine deutlich geringere Spannung ab, als im Fall eines geschlossenen MOSFETs 34a.

Der Spannungsabfall über dem Spannungsteiler 64 kann, im Fall eines offenen MOSFETs 34a, sogar gegen 0V gehen oder 0V betragen. Allerdings könnte ein Stromfluss in Richtung des Spanungsteilers 64 diesen Wert erheblich verändern und damit zu einer Verfälschung der Messergebnisse führen. Der Stromfluss würde aufgrund des hohen Widerstands des geöffneten MOSFETs 34a in erheblichem Maß, wenn nicht sogar ausschließlich, über den Spannungsteiler 64 fließen. Ein solcher Stromfluss kann beispielsweise von dem Pfad mit geschlossenem MOSFET 36a stammen. Zusätzlich oder alternativ kann solch ein Stromfluss ein Rückfluss von der Last 40 sein. Zusätzlich oder alternativ kann ein solcher Stromfluss stammen von einer Spannungsquelle, die anstelle oder zusätzlich zu der Last 40 ausgangsseitig angeschlossen ist. Die Halbleiterdiode 34b sorgt jedenfalls dafür, dass kein oder zumindest nahezu kein Strom in Sperrrichtung der Halbleiterdiode 34c bei geöffnetem MOSFET 34a in den Spannungsteiler 64 fließt. Aus dem Verhältnis der Widerstandswerte der Widerstände 64a, 64b ergibt sich die jeweils über den Widerständen 64a, 64b abfallende Spannung, die dann ebenfalls sehr gering ist oder sogar zumindest nahezu 0V beträgt. Sind beispielsweise die Widerstandswerte der Widerstände 64a, 64b gleich groß, fällt jeweils eine gleich große, aber sehr geringe Spannung über den Widerständen 64a, 64b ab, genauer gesagt, im Fall eines offenen MOSFET 34a des ersten Halbleiterbauelement-Paars 34 jeweils eine sehr geringe Spannung von beispielsweise zumindest nahezu 0V.

Über dem Spannungsteiler 66 fällt eine unterschiedliche Spannung ab, je nachdem, ob der MOSFET 36a des zweiten Halbleiterbauelement-Paars 36 geschlossen oder offen ist. Ist der MOSFET 36a des zweiten Halbleiterbauelement-Paars 36 in einem geschlossenen Zustand, fällt an dem Spannungsteiler 66 eine Spannung ab, deren Wert dem Wert der Spannung U1 der Spannungsquelle 10 entspricht. Aus dem Verhältnis der Widerstandswerte der Widerstände 66a, 66b ergibt sich die jeweils über den Widerständen 66a, 66b abfallende Spannung. Sind beispielsweise die Widerstandswerte der Widerstände 66a, 66b gleich groß, fällt jeweils eine gleich große Spannung über den Widerständen 66a, 66b ab, genauer gesagt, im Fall eines geschlossenen MOSFETs 36a des zweiten Halbleiterbauelement-Paars 36 jeweils die Hälfte der Spannung der Spannungsquelle 10.

Ist der MOSFET 36a des zweiten Halbleiterbauelement-Paars 36 in einem offenen Zustand fällt über dem MOSFET 36a des zweiten Halbleiterbauelement-Paars 36 eine relativ hohe Spannung ab und somit an dem Spannungsteiler 66 eine deutlich geringere Spannung ab, als im Fall eines geschlossenen MOSFETs 36a. Der Spannungsabfall über dem Spannungsteiler 66 kann, im Fall eines offenen MOSFETs 36a, sogar gegen 0V gehen oder 0V betragen. Allerdings könnte ein Stromfluss in Richtung des Spanungsteilers 66 diesen Wert erheblich verändern und damit zu einer Verfälschung der Messergebnisse führen. Der Stromfluss würde aufgrund des hohen Widerstands des geöffneten MOSFETs 36a in erheblichem Maß, wenn nicht sogar ausschließlich, über den Spannungsteiler 66 fließen. Ein solcher Stromfluss kann beispielsweise von dem Pfad mit geschlossenem MOSFET 34a stammen. Zusätzlich oder alternativ kann solch ein Stromfluss ein Rückfluss von der Last 40 sein. Zusätzlich oder alternativ kann ein solcher Stromfluss stammen von einer Spannungsquelle, die anstelle oder zusätzlich zu der Last 40 ausgangsseitig verschaltet ist. Die Halbleiterdiode 36c sorgt jedenfalls dafür, dass kein oder zumindest nahezu kein Strom in Sperrrichtung der Halbleiterdiode 36c bei geöffnetem MOSFET 34a in den Spannungsteiler 66 fließt. Aus dem Verhältnis der Widerstandswerte der Widerstände 66a, 66b ergibt sich die jeweils über den Widerständen 66a, 66b abfallende Spannung, die dann ebenfalls sehr gering ist oder sogar zumindest nahezu 0V beträgt. Sind beispielsweise die Widerstandswerte der Widerstände 66a, 66b gleich groß, fällt jeweils eine gleich große, aber sehr geringe Spannung über den Widerständen 66a, 66b ab, genauer gesagt, im Fall eines offenen MOSFETs 36a des zweiten Halbleiterbauelement-Paars 36 jeweils eine sehr geringe Spannung von beispielsweise zumindest nahezu 0V.

Der Rest der Schaltung aus Figur 3b entspricht der Schaltung aus Figur 3a. Demnach wird diesbezüglich auf die obigen Erläuterungen hinsichtlich Figur 3a Bezug genommen.

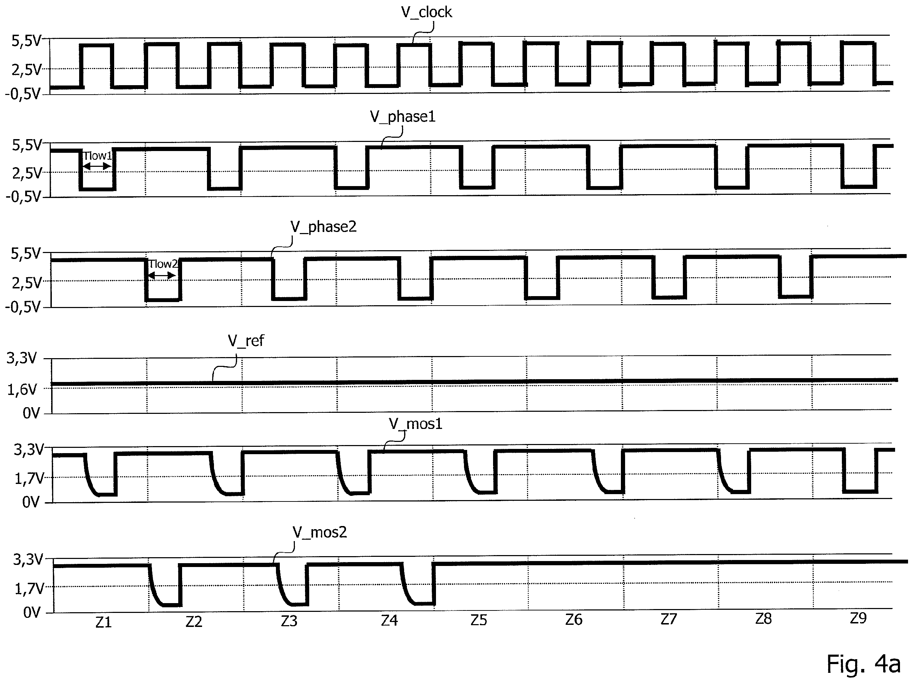

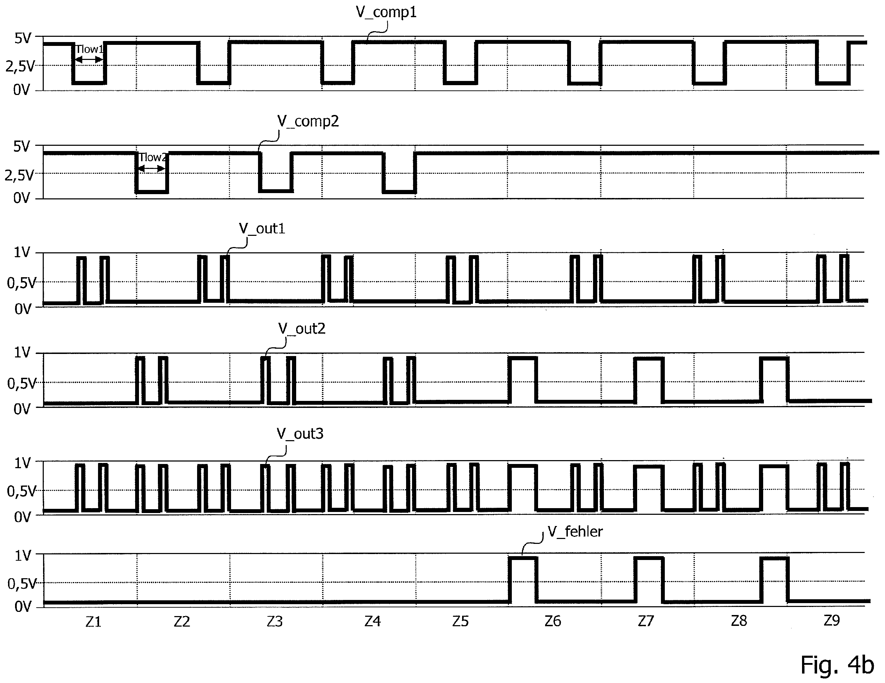

Die Funktionsweise der Ausgestaltung aus Figur 3a wird nun anhand von beispielhaften Signalverläufen aus Figuren 4a und 4b genauer beschrieben. Die Erläuterungen gelten entsprechend für die Variante aus Figur 3b mit den zuvor in Bezug auf Figur 3b beschriebenen Unterschieden.

In den Figuren 4a und 4b sind Signalverläufe jeweils über der Zeit gezeigt. Dabei zeigt jeweils die Ordinate die jeweilige elektrische Größe, z.B. Strom oder Spannung, und die Abszisse die Zeit. Die Abszisse ist in mehrere Bereiche (genauer gesagt, neun Bereiche) unterteilt, die jeweils hierin als Zeitfenster Z1 bis Z9 bezeichnet werden.

Die MOSFETs 34a, 34b, 36a, 36b sind in dem Beispiel als selbstsperrende n-Kanal-MOSFETS ausgebildet. Daher sind die MOSFETS 34a, 34b, 36a, 36b in einem offenen Zustand und leiten keinen Strom, wenn die die Spannung zwischen Gate und Source einen Schwellwert nicht überschreitet (selbstsperrend; auch als Anreicherungstyp bezeichnet). Ferner sind die MOSFETS 34a, 34b, 36a, 36b in einem geschlossenen Zustand und leiten Strom, wenn die die Spannung zwischen Gate und Source einen Schwellwert überschreitet. Der Schwellwert liegt jeweils unter den beispielhaft in Figur 4a und 4b angenommenen Maximalerwerte der Ausgangssignale der Gate-Treiber 60a, 60b.

Ein Taktsignal V_clock wird in den Phasengenerator 32 eingegeben. Ein Beispiel für ein solches Taktsignal V_clock ist in Figur 4a zu sehen. Der Phasengenerator 32 kann aus dem Taktsignal V_clock die Ansteuersignale V_phase1, V_phase2 erzeugen. Mit den beiden Ansteuersignalen V_phase1, V_phase2 werden jeweils die zugehörigen Gate-Treiber 60a, 60b angesteuert. Die beiden Ansteuersignale V_phase1, V_phase 2 haben grundsätzlich den gleichen Verlauf, sind jedoch gegeneinander um einen bestimmten Betrag verschoben. Wie in Bezug auf die beispielhaften Signalverläufe in den Figuren 4a und 4b zu erkennen, beginnen beide Ansteuersignale V_phase1, V_phase2 im ersten Zeitfenster Z1 mit einem Wert von ungefähr 5V. Dies entspricht einem hohen Pegel, auch als HIGH bezeichnet (digitale 1). Die Gate-Treiber 60a, 60b setzen die Ansteuersignale auf das Bezugspotential der MOSFETS 34a, 34b und der MOSFETS 36a, 36b um. Dabei kann beispielhaft davon ausgegangen werden, dass der Verlauf des Ausgangssignals des Gate-Treibers 60a dem Verlauf des Ansteuersignals V_phase1 entspricht, wobei der Pegel des Ausgangssignals auf die MOSFETS 34a, 34b abgestimmt ist, wie z.B. im Vergleich zu dem Ansteuersignal V_phase1 verringert ist. Ferner kann beispielhaft davon ausgegangen werden, dass der Verlauf des Ausgangssignals des Gate-Treibers 60b dem Verlauf des Ansteuersignals V_phase2 entspricht, wobei der Pegel des Ausgangssignals auf die MOSFETS 36a, 36b abgestimmt ist, wie z.B. im Vergleich zu dem Ansteuersignal V_phase2 verringert ist. Die MOSFETS 34a, 34b und die MOSFETS 36a, 36b schalten jeweils ein, wenn die Spannung zwischen Gate und Source einen bestimmten Schwellwert / Schwellspannungswert übersteigt. Rein beispielhaft seien hier 4V als Schwellwert genannt. Aufgrund der HIGH-Pegel der Ansteuersignale V_phase1, V_phase2 und der Ausgangssignale der Gate-Treiber 60a, 60b liegt eine Spannung zwischen Gate und Source der beiden MOSFETs 34a, 34b des ersten MOSFET-Paars 34 und zwischen Gate und Source der beiden MOSFETs 36a, 36b des zweiten MOSFET-Paars 36 an, die den Schwellwert der genannten MOSFETs 34a, 34b, 36a, 36b übersteigt. Sowohl die MOSFETs 34a, 34b des ersten MOSFET-Paars 34 als auch die MOSFETs 36a, 36b des zweiten MOSFET-Paars 36 befinden sich daher in einem geschlossenen Zustand.

In Bezug auf die beispielhafte Ausgestaltung aus Figur 3a fällt bei geschlossenen MOSFETs 34a, 34b des ersten MOSFET-Paars 34 und bei geschlossenen MOSFETs 36a, 36b des zweiten MOSFET-Paars 36 eine Spannung über allen Spannungsteilern 62, 64, 66 ab, die zumindest nahezu der Spannung U1 der Spannungsquelle 10 entspricht. Dies liegt daran, dass die über einem geschlossenen MOSFET abfallende Spannung zumindest nahezu 0V beträgt. Anhand der Maschenregel lässt sich erkennen, dass sowohl über dem Referenzspannungsteiler 62, als auch über den Spannungsteilern 64, 66 jeweils zumindest nahezu die Spannung U1 der Spannungsquelle 10 abfällt. Im beispielhaften Fall der Figur 3a sind die Widerstandswerte der Spannungsteiler 62, 64, 66 derart bemessen, dass bei geschlossenen/eingeschalteten MOSFETS 34a, 34b des ersten MOSFET-Paars 34 und bei geschlossenen/eingeschalteten MOSFETS 36a, 36b des zweiten MOSFET-Paars 36 die über den Widerständen 64b, 66b abfallende Spannung (deutlich) größer ist als die über dem Referenzwiderstand 62b abfallende Spannung V_ref. Dies kann beispielsweise erreicht werden, indem das Verhältnis des Widerstandswerts 64b zu dem Widerstandswert 64a (deutlich) größer ist als das Verhältnis des Widerstandswerts 62b zu dem Widerstandswert 62a und indem das Verhältnis des Widerstandswerts 66b zu dem Widerstandswert 66a (deutlich) größer ist als das Verhältnis des Widerstandswerts 62b zu dem Widerstandswert 62a. Aufgrund der Spannungsteilerregel fällt in diesem Fall über den Widerständen 64b, 66b eine (deutlich) größere Spannung ab als die Referenzspannung V_ref über dem Widerstand 62b, selbst wenn über den jeweiligen Spannungsteilern 62, 64, 66 insgesamt jeweils die gleiche Spannung U1 abfällt. Das heißt, bei geschlossenen MOSFETs 34a, 34b, 36a, 36b ist die Spannung V_mos1 (deutlich) größer als die Referenzspannung V_ref und ist die Spannung V_mos2 (deutlich) größer als die Referenzspannung V_ref. Die Werte für V_mos1, V_ref erhält der Komparator 70a und die Werte für V_mos2, V_ref erhält der Komparator 70b als Eingangswerte.

Nach einer Zeit wird das erste Ansteuersignal V_phase1 in dem ersten Zeitfenster Z1 für eine Zeitspanne Tlow1 auf eine Spannung von ungefähr 0V gesetzt. Dies entspricht einem tiefen Pegel, auch als LOW-Pegel (digitale 0) bezeichnet. In diesem Fall liegt zwischen Gate und Source der beiden MOSFETs 34a, 34b des ersten MOSFET-Paars 34, wenn überhaupt, nur noch eine sehr geringe Spannung an, die unter dem Schwellwert der MOSFETs 34a, 34b liegt. Die MOSFETs 34a, 34b gehen daher in einen offenen Zustand über. Während der gleichen Zeitspanne Tlow1 des ersten Zeitfensters Z1 befindet sich das zweite Ansteuersignal V_phase2 weiter auf einem HIGH-Pegel. Die MOSFETs 36a, 36b des zweiten MOSFET-Paars 36 sind daher weiter geschlossen. Da die MOSFETs 34a, 34b des ersten MOSFET-Paars 34 in der ersten Zeitspanne Tlow1 des ersten Zeitfensters Z1 offen sind und die MOSFETs 36a, 36b des zweiten MOSFET-Paars 36 in der ersten Zeitspanne Tlow1 des ersten Zeitfensters Z1 geschlossen sind, ändert sich potentiell der Spannungsabfall über den Spannungsteilern 64, 66. Da die MOSFETs 36a, 36b des zweiten MOSFET-Paars 36 geschlossen bleiben, ändert sich der Spanungsabfall über dem Spannungsteiler 66 nicht, d.h. die über dem Spannungsteiler 66 abfallende Spannung entspricht weiterhin im Wesentlichen der Spannung über dem Referenzspannungsteiler 62 und damit der Spannung U1 der Spannungsquelle 10. Demnach liegt bei der oben geschilderten Wahl der Widerstandsverhältnisse der Spannungsteiler 62, 64, 66 die Spannung V_mos2 an/über dem Widerstand 66b (deutlich) über der Referenzspannung V_ref an/über dem Widerstand 62b.

Da die MOSFETs 34a, 34b des ersten MOSFET-Paars 34 in einen offenen Schaltzustand übergehen, ändert sich der Spanungsabfall über dem Spannungsteiler 64. Ist der MOSFET 34a offen, fällt eine relativ hohe Spannung über dem MOSFET 34a ab.

Über dem Spannungsteiler 64 hingegen fällt nur noch eine deutlich geringere Spannung ab als die Spannung U1 der Spannungsquelle oder sogar eine Spannung von zumindest nahezu 0V. Folglich liegt die Spannung V_mos1 über dem Widerstand 64b deutlich unter der Referenzspannung V_ref über dem Widerstand 62b, und beispielsweise bei zumindest nahezu 0V. Die Werte für V_mos1, V_ref erhält der Komparator 70a und die Werte für V_mos2, V_ref erhält der Komparator 70b als Eingangswerte.

Steigt die Spannung des Ansteuersignals V_phase1 wieder auf den HIGH-Pegel, schließen sich die MOSFETs 34a, 34b wieder und die über dem Spannungsteiler 64 abfallende Spannung nimmt wieder den Wert der Spannung U1 der Spannungsquelle 10 an. Die Werte für V_mos1, V_ref erhält der Komparator 70a und die Werte für V_mos2, V_ref erhält der Komparator 70b als Eingangswerte.

Nach einer Zeit wird das zweite Ansteuersignal V_phase2 in dem zweiten Zeitfenster Z2 für eine Zeitspanne Tlow2 auf eine Spannung von ungefähr 0V gesetzt. Dies entspricht einem tiefen Pegel, auch als LOW-Pegel (digitale 0) bezeichnet. In diesem Fall liegt zwischen Gate und Source der beiden MOSFETs 36a, 36b des zweiten MOSFET-Paars 36, wenn überhaupt, nur noch eine sehr geringe Spannung an, die unter dem Schwellwert der MOSFETs 36a, 36b liegt. Die MOSFETs 36a, 36b gehen daher in einen offenen Zustand über. Während der gleichen Zeitspanne Tlow2 des zweiten Zeitfensters Z2 befindet sich das erste Ansteuersignal V_phase1 weiter auf einem HIGH-Pegel. Die MOSFETs 34a, 34b des ersten MOSFET-Paars 34 sind daher weiter geschlossen. Da die MOSFETs 36a, 36b des zweiten MOSFET-Paars 36 in der zweiten Zeitspanne Tlow2 des zweiten Zeitfensters Z2 offen sind und die MOSFETs 34a, 34b des ersten MOSFET-Paars 34 in der zweiten Zeitspanne Tlow2 des zweiten Zeitfensters Z2 geschlossen sind, ändert sich potentiell der Spannungsabfall über den Spannungsteilern 64, 66. Da die MOSFETs 34a, 34b des ersten MOSFET-Paars 34 geschlossen bleiben, ändert sich der Spanungsabfall über dem Spannungsteiler 64 nicht, d.h. die über dem Spannungsteiler 64 abfallende Spannung entspricht weiterhin im Wesentlichen der Spannung über dem Referenzspannungsteiler 62 und damit der Spannung U1 der Spannungsquelle 10. Demnach liegt aufgrund der oben geschilderten Wahl der Widerstandsverhältnisse der Spannungsteiler 62, 64, 66 die Spannung V_mos1 an/über dem Widerstand 64b (deutlich) über der Referenzspannung V_ref an/über dem Widerstand 62b.

Da die MOSFETs 36a, 36b des zweiten MOSFET-Paars 36 in einen offenen Schaltzustand übergehen, ändert sich der Spanungsabfall über dem Spannungsteiler 66. Ist der MOSFET 36a offen, fällt eine relativ hohe Spannung über dem MOSFET 36a ab. Über dem Spannungsteiler 66 hingegen fällt nur noch eine deutlich geringere Spannung ab als die Spannung U1 der Spannungsquelle oder sogar eine Spannung von zumindest nahezu 0V. Folglich liegt die Spannung V_mos2 über dem Widerstand 66b deutlich unter der der Referenzspannung V_ref über dem Widerstand 62b, und beispielsweise bei zumindest nahezu 0V. Die Werte für V_mos1, V_ref erhält der Komparator 70a und die Werte für V_mos2, V_ref erhält der Komparator 70b als Eingangswerte.

Steigt die Spannung des Ansteuersginals V_phase2 und die Spannung des Ausgangssignals Gate-Treibers 60b wieder auf den HIGH-Pegel, schließen sich die MOSFETs 36a, 36b wieder und die über dem Spannungsteiler 66 abfallende Spannung nimmt wieder den Wert der Spannung U1 der Spannungsquelle 10 an. Demnach liegt aufgrund der oben geschilderten Wahl der Widerstandsverhältnisse der Spannungsteiler 62, 64, 66 die Spannung V_mos2 an/über dem Widerstand 66b wieder (deutlich) über der Referenzspannung V_ref an/über dem Widerstand 62b. Die Werte für V_mos1, V_ref erhält der Komparator 70a und die Werte für V_mos2, V_ref erhält der Komparator 70b als Eingangswerte.

Entsprechend den Verläufen der Ansteuersignale V_phase1, V_phase2 ändern sich daher die Verläufe der Spannungen V_mos1, V_mos2 über den Widerständen 64b, 66b der Spannungsteiler 64, 66 wie dies beispielhaft in der Figur 4a dargestellt ist. Dementsprechend erhalten die Komparatoren 70a, 70b unterschiedliche Eingangswerte in Abhängigkeit von dem Verlauf der Spannungen V_ref, V_mos1, V_mos2. Bereits aus dem Verlauf der Spannung V_mos2 lässt sich erkennen, dass beim Schalten des zweiten MOSFET-Paars 36 ab dem sechsten Zeitfenster Z6 wohl ein Fehler vorliegt.

Befinden sich die MOSFETs 34a, 34b des ersten MOSFET-Paars 34 und die MOSFETs 36a, 36b des zweiten MOSFET-Paars 36 jeweils in einem geschlossenen Zustand liegen die Werte der Spannungen V_mos1, V_mos2, wie beschrieben, (deutlich) über dem Wert der Referenzspannung V_ref. Damit erhält der Komparator 70a an seinem nicht-invertierenden Eingang, als Spannung V_mos1, einen (deutlich) höheren Wert als an seinem invertierenden Eingang, als Spannung V_ref. Daher stellt der Komparator 70a fest, dass die Größe V_mos1 zumindest so groß, eigentlich größer, ist wie der Referenzwert V_ref und gibt dementsprechend einen HIGH-Pegel (eine 1) aus (siehe Signal V_comp1). Ferner erhält der Komparator 70b an seinem nicht-invertierenden Eingang, als Spannung V_mos2, einen (deutlich) höheren Wert als an seinem invertierenden Eingang, als Spannung V_ref. Daher stellt der Komparator 70b fest, dass die Größe V_mos2 zumindest so groß, eigentlich größer, ist als der Referenzwert V_ref und gibt dementsprechend einen HIGH-Pegel (eine 1) aus (siehe Signal V_comp2).

Befinden sich die MOSFETs 34a, 34b in einem offenen Zustand und die MOSFETs 36a, 36b in einem geschlossenen Zustand (siehe z.B. die Zeitspanne Tlow1 in den Zeitfenstern Z1, Z2, Z4, Z5, Z6, Z8, Z9) ergibt sich als Spannung V_mos1 über dem Wiederstand 64b eine Spannung von zumindest nahezu 0V und als Spannung V_mos2 über dem Widerstand 66b ein Maximalwert von zumindest V_ref. Daher stellt der erste Komparator 70a fest, dass der Wert seiner Eingangsgröße V_mos1 unter dem Wert seiner anderen Eingangsgröße V_ref (Referenzgröße) liegt und gibt dementsprechend einen LOW-Pegel (digitale 0) aus (siehe Signal V_comp1). Ferner stellt der zweite Komparator 70b fest, dass der Wert seiner einen Eingangsgröße V_mos2 nicht unter dem Wert seiner anderen Eingangsgröße V_ref (Referenzgröße) liegt (denn der Wert V_mos2 ist (deutlich) größer als der Wert der Referenzgröße V_ref) und gibt dementsprechend einen HIGH-Pegel (eine 1) aus (siehe Signal V_comp2).

Befinden sich die MOSFETs 34a, 34b des ersten MOSFET-Paars 34 in einem geschlossenen Zustand und die MOSFETs 36a, 36b des zweiten MOSFET-Paars 36 in einem offenen Zustand (siehe z.B. die Zeitspanne Tlow2 in dem zweiten Zeitfenster Z2, dem dritten Zeitfenster Z3 und dem vierten Zeitfenster Z4) ergibt sich als Spannung V_mos2 über dem Widerstand 66b eine Spannung von zumindest nahezu 0V und als Spannung V_mos1 über dem Widerstand 64b ein Maximalwert (deutlich) über dem Referenzwert V_ref. Daher stellt der erste Komparator 70a fest, dass der Wert seiner Eingangsgröße V_mos1 nicht unter dem Wert seiner anderen Eingangsgröße V_ref (Referenzgröße) liegt (denn der Wert V_mos1 ist (deutlich) größer als der Wert der Referenzgröße V_ref) und gibt dementsprechend einen HIGH-Pegel (digitale 1) aus (siehe Signal V_comp1). Ferner stellt der zweite Komparator 70b fest, dass der Wert seiner einen Eingangsgröße V_mos2 unter dem Wert seiner anderen Eingangsgröße V_ref (Referenzgröße) liegt und gibt dementsprechend einen LOW-Pegel (eine 0) aus (siehe Signal V_comp2).

Bei offenen MOSFETs 34a, 34b des ersten MOSFET-Paars 34 ergibt sich daher auf ungefährer zeitlicher Höhe des LOW-Pegels des ersten Ansteuersignals V_phase1, d.h. ungefähr auf Höhe der Zeitspanne Tlow1 im ersten Zeitfenster Z1, im zweiten Zeitfenster Z2, im vierten Zeitfenster Z4, im fünften Zeitfenster Z5, im sechsten Zeitfenster Z6, im achten Zeitfenster Z8 und im neunten Zeitfenster Z9 ein tiefer Pegel im Ausgangssignal V_comp1 des ersten Komparators 70a.

Das Ausgangssignal V_comp1 des ersten Komparators 70a und das erste Ansteuersignal V_phase1 werden nun in dem ersten XOR-Gatter 72a miteinander verglichen. In einem idealen Fall ohne Laufzeit- und/oder Schaltverzögerungen würde das XOR-Gatter 72a aufgrund einer idealen Übereinstimmung der Signale V_comp1 und V_phase1 keine Unterschiede feststellen und stets einen LOW-Pegel (digitale 0) ausgeben. Im realen, nicht-idealen Fall wird das erste XOR-Gatter 72a durch Laufzeitverzögerungen und/oder Schaltverzögerungen jeweils entstandene Doppelpeaks als Ausgangsgröße V_out1 des ersten XOR-Gatters 72a ausgeben. Da die MOSFETs 34a, 34b in jeder Zeitspanne Tlow1 zuverlässig geschaltet haben, ergeben sich im Bereich jeder Zeitspanne Tlow1 derartige Doppelpeaks.

Bei offenen MOSFETs 36a, 36b des zweiten MOSFET-Paars 36 ergibt sich auf ungefährer zeitlicher Höhe des LOW-Pegels des zweiten Ansteuersignals V_phase2 ein tiefer Pegel im Ausgangssignal V_comp2 des ersten Komparators 70b. Wird beispielhaft angenommen, dass zumindest einer der MOSFETs 36a, 36b, beispielsweise der MOSFET 36a, in den Zeitfenster Z2, Z3, Z4 korrekt schaltet (öffnet), in den Zeitfenstern Z6, Z7, Z8 hingegen nicht korrekt schaltet (öffnet), ergibt sich daher auf ungefährer zeitlicher Höhe des LOW-Pegels des zweiten Ansteuersignals V_phase2 in den Zeitfenstern Z2, Z3, Z4 ein tiefer Pegel im Ausgangssignal V_comp2 des ersten Komparators 70b, während in den Zeitfenster Z6, Z7, Z8 der Pegel hoch bleibt, da zumindest einer der MOSFETs 36a, 36b, beispielsweise der MOSFET 36a, nicht korrekt öffnet.

Das Ausgangssignal V_comp2 des zweiten Komparators 70b und das zweite Ansteuersignal V_phase2 werden nun in dem zweiten XOR-Gatter 72b miteinander verglichen. In einem idealen Fall ohne Laufzeit- und/oder Schaltverzögerungen würde das XOR-Gatter 72b aufgrund einer idealen Übereinstimmung der Signale V_comp2 und V_phase2 keine Unterschiede feststellen und stets einen LOW-Pegel (digitale 0) ausgeben. Im realen, nicht-idealen Fall wird das zweite XOR-Gatter 72b durch Laufzeitverzögerungen und/oder Schaltverzögerungen jeweils entstandene Doppelpeaks als Ausgangsgröße V_out2 des zweiten XOR-Gatters 72b ausgeben. Da die MOSFETs 36a, 36b in der Zeitspanne Tlow2 der Zeitfenster Z2, Z3, Z4 zuverlässig geschaltet haben, ergeben sich im Bereich der Zeitspanne Tlow2 der Zeitfenster Z2, Z3, Z4 derartige Doppelpeaks.

Wird nun beispielhaft, wie in Figur 4a gezeigt, angenommen, dass in dem sechsten Zeitfenster Z6, siebten Zeitfenster Z7 und achten Zeitfenster Z8 einer der MOSFETs 36a, 36b, beispielsweise der MOSFET 36a, nicht korrekt öffnet, obwohl das zweite Ansteuersignal V_phase2 in der Zeitspanne Tlow2 einen LOW-Pegel annimmt, bleibt der MOSFET 36a in dem sechsten Zeitfenster Z6, siebten Zeitfenster Z7 und achten Zeitfenster Z8 in dem geschlossenen Zustand. Wie erläutert, fällt in diesem Fall über dem Widerstand 66b als Spannung V_mos2 eine Spannung ab, die (deutlich) über dem Wert der Referenzspannung V_ref über dem Widerstand 62b liegt. Beide Komparatoren 70a, 70b stellen daher, während Tlow2 in den Zeitfenstern Z6, Z7, Z8, fest, dass die Spannungswerte V_mos1, V_mos2 mindestens dem Referenzspannungswert V_ref entsprechen, eigentlich deutlich darüber liegen. Daher stellt der erste Komparator 70a fest, dass der Wert seiner einen Eingangsgröße V_mos1 nicht unter dem Wert seiner anderen Eingangsgröße V_ref (Referenzgröße) liegt (denn der Wert V_mos1 ist (deutlich) größer als der Wert der Referenzgröße V_ref) und gibt dementsprechend einen HIGH-Pegel (digitale 1) aus (siehe Signal V_comp1). Ferner stellt der zweite Komparator 70b fest, dass der Wert seiner einen Eingangsgröße V_mos2 nicht unter dem Wert seiner anderen Eingangsgröße V_ref (Referenzgröße) liegt (denn der Wert V_mos2 ist (deutlich) größer als der Wert der Referenzgröße V_ref) und gibt dementsprechend einen HIGH-Pegel (digitale 1) aus (siehe Signal V_comp2). Beide Komparatoren 70a, 70b geben daher im sechsten Zeitfenster Z6, siebten Zeitfenster Z7 und achten Zeitfenster Z8 für die Signale V_comp1, V_comp2 auch während der Zeitspanne Tlow2 einen HIGH-Pegel aus. Die XOR-Verknüpfung des Ausgangs des zweiten Komparators 70b mit dem zweiten Ansteuersignal V_phase2 führt daher zu einem (einzigen) HIGH-Pegel ungefähr während der Zeitspanne Tlow2 des sechsten Zeitfensters Z6, des siebten Zeitfenster Z7 und des achten Zeitfenster Z8 (V_out2), nicht zu einem Doppelpeak.

Die Ausgänge des ersten XOR-Gatters 72a und des zweiten XOR-Gatters 72b werden als Eingangsgrößen in ein OR-Gatter 74 gegeben. Der Ausgang des OR-Gatters 74 ist daher eine Überlagerung der Ausgänge des ersten 72a und des zweiten XOR-Gatters 72b. Das Ausgangssignal V_out3 des OR-Gatters 74 zeigt daher im ersten Zeitfenster Z1 bis fünften Zeitfenster Z5 einen Doppelpeak, der jeweils das Öffnen des ersten und zweiten MOSFET-Paars 34, 36 während Tlow1 und Tlow2 anzeigt, und ebenso im sechsten Zeitfenster Z6, achten Zeitfenster Z8 und neunten Zeitfenster Z9 einen Doppelpeak, der jeweils das Öffnen des ersten MOSFET-Paars 34 während Tlow1 anzeigt.

Die OR-Verknüpfung der Ausgänge beider XOR-Gatter 72a, 72b führt im sechsten Zeitfenster Z6, siebten Zeitfenster Z7 und achten Zeitfenster Z8 ferner jeweils zu einem (einzigen) Peak (zumindest ungefähr auf Höhe der Zeitspanne Tlow2 im sechsten Zeitfenster Z6, siebten Zeitfenster Z7 und achten Zeitfenster Z8). Dieser eine Peak (statt einem durch Laufzeitverzögerungen und/oder Schaltverzögerungen entstandenen Doppelpeak mit jeweils kleinerer Breite jedes Peaks) in dem Ausgangssignal des OR-Gatters 74 (V_out3) zeigt daher einen Fehler beim Öffnen eines der MOSFETs 36a, 36b des zweiten MOSFET-Paars 36, beispielsweise des MOSFETs 36a, an.

Die Erkennung eines Fehlers lässt sich verbessern, indem hinter das OR-Gatter 74 eine Zeitverzögerung geschaltet wird, die im Folgenden teilweise als Zeitverzögerungsglied 76 bezeichnet wird. Die Zeitverzögerung führt dazu, dass nur solche Peaks als Fehler erkannt werden, deren Dauer über einem vorgegebenen zeitlichen Schwellenwert liegt. Die Dauer der Doppelpeaks im ersten Zeitfenster Z1 bis fünften Zeitfenster Z5 (und ebenso im sechsten Zeitfenster Z6, achten Zeitfenster Z8 und neunten Zeitfenster Z9) liegt jeweils unter dem zeitlichen Schwellenwert. Daher gibt der Ausgang des Zeitverzögerungsglieds 76 einen LOW-Pegel aus (siehe Signal V_fehler). Die Dauer der Peaks im sechsten Zeitfenster Z6, siebten Zeitfenster Z7 und achten Zeitfenster Z8 zur Zeitspanne Tlow2 liegen hingegen über dem zeitlichen Schwellenwert. Das Zeitverzögerungsglied 76 gibt daher im sechsten Zeitfenster Z6, siebten Zeitfenster Z7

**15**

und achten Zeitfenster Z8 für eine bestimmte Dauer, die zumindest nahezu der Zeitspanne Tlow2 entspricht, einen HIGH-Pegel aus (siehe Signal V_fehler).

Gemäß einer spezifischen Realisierung der Zeitverzögerung kann das Zeitverzögerungsglied 76 als Einschaltverzögerung ausgebildet sein oder eine Einschaltverzögerung bewirken. In diesem Fall kann das Zeitverzögerungsglied 76 beispielsweise ein zeitlich verzögertes Einschalten bewirken oder zeitlich verzögert einschalten. Die zeitliche Verzögerung kann mindestens dem Betrag (in zeitlicher Sicht) eines der Pulse der Doppelpulse der Signale Vout_1, Vout_2, Vout_3 entsprechen oder über diesen liegen. Dadurch werden die jeweiligen Pulse dieser Doppelpulse unterdrückt oder ausgeblendet und nur die längeren Pulse (d.h. die Pulse mit einer Breite größer als die zeitliche Verzögerung bzw. größer als die Breite jedes Peaks der Doppelpeaks) werden, jeweils verkürzt durch den Betrag der zeitlichen Verzögerung im Fehlersignal V_fehler ausgegeben. Dies ist in Fig. 4b zu erkennen, in der ein gültiges Fehlersignal V_fehler gezeigt ist. Bei dem Signal V_fehler ist jeweils die steigende Flanke eines Fehlerpulses um den Betrag der Einschaltverzögerung zur steigenden Flanke eines langen Peaks beispielsweise im Signal Vout_3 versetzt oder verkürzt (d.h. mindestens um die Breite eines Pulses eines Doppelpulses/Doppelpeaks verkürzt). Die fallende Flanke des Pulses des Fehlersignals V_fehler fällt hingegen zur selben Zeit ab wie der entsprechende Puls bei dem Signal Vout_3, da es sich lediglich um eine Einschaltverzögerung handelt und nicht um eine Ausschaltverzögerung. Dies betrifft alle Zeitslots mit Fehlern, d.h. Z6, Z7 und Z8. Die Pulse jedes Doppelpulses werden dagegen durch die Einschaltverzögerung unterdrückt. Bei diesen handelt es sich schließlich nicht um tatsächliche/gültige Fehlerpulse.

Im Ergebnis zeigt das Ausgangssignal V_fehler des Zeitverzögerungsglieds 76 nur dann einen Peak, wenn ein Fehler beim Schalten eines der MOSFETS 34a, 34b, 36a, 36b vorliegt. Laufzeitverzögerungen werden hingegen unterdrückt. Der Ausgang der Zeitverzögerung 76 kann daher als Fehlersignal V_fehler bezeichnet werden. Mittels einer Erkennungsschaltung können die Peaks im Fehlersignal V_fehler automatisch erkannt werden. Anhand der Peaks und der Ansteuersignale kann die Erkennungsschaltung unmittelbar darauf schließen, in welchem der beiden MOSFET-Paare 34, 36 nicht korrekt geschaltet wurde. Eine genaue Bestimmung, ob, bei einem Fehler im MOSFET-Paar 36, der MOSFET 36a, der MOSFET 36b oder beide MOSFETS 36a, 36b nicht korrekt geschaltet haben, ist mit der gezeigten Schaltung nicht möglich, ist jedoch auch nicht nötig für die angedachten Anwendungen. Denn, schaltet zumindest einer der MOSFETs 34a, 34b oder MOSFETs 36a, 36 nicht, wird das betroffene MOSFET-Paar 34, 36 als Ganzes ausgetauscht. Der Fehler kann daher nicht nur zeitnah erkannt werden sondern es kann zeitnah ein Austausch des betroffenen Bauteils oder eine andere Reaktion zur Behebung des Fehlers erfolgen.

Die Figuren 3a, 4a und 4b können wie folgt zusammengefasst werden. In der Schaltung aus Figur 3a werden insgesamt vier MOSFETs 34a, 34b, 36a, 36b, beispielsweise als Leistungshalbleiter, und genauer gesagt jeweils zwei MOSFET-Paare 34, 36 parallel geschaltet. Die MOSFET-Paare 34, 36 sind jeweils gebildet durch zwei antiseriell geschaltete MOSFETs 34a, 34b, 36a, 36b. Durch eine Logik werden beide Leistungshalbleiter-Paare 34, 36 abwechselnd aus- und eingeschaltet. Um die Versorgung der angeschlossenen Lasten 40 gewährleisten zu können, muss immer mindestens ein Leistungshalbleiter-Paar 34, 36 eingeschaltet sein. Über jeweils einen Spannungsteiler 64, 66 am gemeinsamen Sourceanschluss jedes Leistungshalbleiter-Paars 34, 36 wird die Spannung an diesem Punkt gemessen (Pfadspannungsteiler). Außerdem verfügt die Schaltung über einen weiteren Spannungsteiler 62 auf der Seite der Spannungsquelle 10 (Referenzspannungsteiler). Wenn beide MOSFET-Paare 34, 36 an (geschlossen) sind, wird an dem Widerstand 64b des Spannungsteilers 64 (Pfadspannungsteiler) und an dem Widerstand 66b des Spannungsteilers 66 (Pfadspannungsteiler) jeweils eine (deutlich) größere Spannung gemessen als an dem Widerstand 62b des Referenzspannungsteilers 62. Sobald eines der beiden MOSFET-Paare 34, 36, genauer gesagt zumindest einer der MOSFETs 34a, 34b, 36a, 36b der MOSFET-Paare 34, 36, abschaltet, fällt die Spannung an dem betroffenen Spannungsteiler 64, 66 auf einen Wert von 0V (oder zumindest deutlich geringer als die Spannung am Referenzspannungsteiler 62). Durch zwei Komparatoren 70a, 70b (Vergleicher) wird das Ausgangssignal der beiden Pfadspannungsteiler 64, 66 mit dem Spannungswert am Referenzspannungsteiler 62 verglichen und durch die Komparatoren 70a, 70b in digitale Signale umgewandelt. Die Signalform an den Ausgängen der Komparatoren 70a, 70b entspricht damit in groben Zügen der Signalfolge, mit der der jeweilige MOSFET-Paare 34, 36, angesteuert werden. Durch Vergleichen des Ansteuersignals der MOSFET-Paare 34, 36 mit dem Ausgangssignal des jeweiligen Komparators 70a, 70b mittels Exklusiv-ODER Verknüpfung (XOR-Verknüpfung 72a, 72b) kann nun detektiert werden, ob die MOSFETs 34a, 34b, 36a, 36b der MOSFET-Paare 34, 36 tatsächlich abschalten. Die beiden XOR-verknüpften Signale der beiden MOSFET-Paare 34, 36 werden anschließend durch eine ODER-Verknüpfung 74 zu einem Signal kombiniert und durch eine Einschaltverzögerung 76 gefiltert. Die Einschaltverzögerung 76 ist vorteilhaft, um durch Signallaufzeiten und/oder Schaltverzögerungen ausgelöste fehlerhafte Diagnosen zu unterbinden. Als Fehlersignal V_fehler erhält man eine Pulsfolge, die ungefähr (wenn auch verkürzt) den Ansteuerpulsen des defekten MOSFET-Paars 34, 36 entspricht. Das Ausgangssignal V_fehler der Einschaltverzögerung 76 kann nun durch eine übergeordnete Steuerung eingelesen und verarbeitet werden (nicht dargestellt, aber siehe Steuerung 28 in Figur 2). Alternativ kann durch ein Speicherglied die Pulsfolge in einen statischen Wert gewandelt werden (nicht dargestellt).

Die obige Zusammenfassung gilt entsprechend für die Variante aus Figur 3b, bei welcher einer der Halbleiterschalter jeweils durch eine Halbleiterdiode 34c, 36c ersetzt wird. In der Variante aus Figur 3b schaltet ein Halbleiterschalter-Paar nicht, wenn der einzige Halbleiterschalter nicht schaltet. Die Halbleiterdiode 34c, 36c ermöglicht die genaue Erkennung des Fehlers beim Schalten der Halbleiterschalter.

Auch wenn in der Beschreibung der Ausführungsbeispiele aus den Figuren 2 bis 4b darauf Bezug genommen wurde, zu erkennen, ob das erste 34 und/oder zweite Halbleiterschalter-Paar 36 korrekt von einem geschlossenen in einen offenen Zustand überführt wird, so kann entsprechend aus den Signalverläufen erkannt werden, ob das erste 34 und/oder zweite Halbleiterschalter-Paar 36 korrekt von einem offenen in einen geschlossenen Zustand überführt wird.

Die Erkennung eines nicht schaltendenden Halbleiterschalters des ersten 34 und/oder zweiten Halbleiterschalter-Paars 36 ermöglicht die Verwendung einfacher und kostengünstiger Bauteile und es kann auf eine Reihenschaltung jeweils eines weiteren Halbleiterschalters zu Redundanzzwecken verzichtet werden. Ferner kann aufgrund der Paarbildung die Schaltung bidirektional abschalten, d.h. es können Lasten eingangs- und ausgangsseitig abgeschaltet werden. Die Schaltung arbeitet ferner ohne mehrere Strommessungen und daher verlustarm und effizient. Um die geforderten Sicherheitsziele zu erreichen kommt die Schaltung zudem ohne mehrere in Reihe geschalteter MOSFETs aus.

Auch wenn in der Beschreibung der Ausführungsbeispiele aus den Figuren 2 bis 4b stets nur auf ein erstes 34 und ein zweites Halbleiterschalter-Paar 36 Bezug genommen wird, so sind diese Ausführungsbeispiele und die Erfindung im Allgemeinen nicht auf exakt zwei parallel geschaltete Halbleiterschalter-Paare 34, 36 beschränkt. Ebenso können drei oder mehr als drei Halbleiterschalter-Paare vorgesehen sein. Zusammengefasst können daher mindestens zwei Halbleiterschalter-Paare 34, 36 vorhanden sein und es kann mindestens ein nicht schaltendes Halbleiterschalter-Paar aus diesen mindestens zwei parallel geschalteten Halbleiterschalter-Paaren 34, 36 erkannt werden.

Ein Vorteil der Parallelschaltung mindestens eines dritten Halbleiterschalter-Paares zu dem ersten 34 und zweiten Halbleiterschalter-Paar 36 wird nun in Bezug auf die Figuren 3a bis 4b beschrieben, ohne das mindestens einen dritte Halbleiterschalter-Paar in den Figuren darzustellen.

Wie beschrieben, wird im ersten Zeitfenster Z1 das erste Halbleiterschalter-Paar 34 geöffnet, wenn das erste Ansteuersignal V_phase1 in der Zeitspanne Tlow1 einen LOW-Pegel annimmt. Nach Ablauf der Zeitspanne Tlow1 nimmt das erste Ansteuersignal V_phase1 wieder einen HIGH-Pegel an. Das erste Halbleiterschalter-Paar 34 würde in diesem Fall wieder schließen. Ist zumindest einer der Halbleiter 34a, 34b des ersten Halbleiterschalter-Paars 34 jedoch defekt, bleibt der zumindest eine der Halbleiter 34a, 34b des ersten Halbleiterschalter-Paars 34 offen, d.h. er geht nicht mehr zu, obwohl das erste Ansteuersignal V_phase1 wieder einen HIGH-Pegel angenommen hat. Wie beschrieben, wird im zweiten Zeitfenster Z2 während der Zeitspanne Tlow2 das zweite Halbleiterschalter-Paar 36 öffnen, da das zweite Ansteuersignal während der Zeitspanne Tlow2 einen LOW-Pegel annimmt. Folglich sind während der Zeitspanne Tlow2 sowohl das erste Halbleiterschalter-Paar 34 offen (da zumindest einer der Hableiter 34a, 34b nicht mehr schließt, obwohl er eigentlich geschlossen sein sollte) als auch das zweite Halbleiterschalter-Paar 36 offen (aufgrund des LOW-Pegels des zweiten Ansteuersignals V_phase2). Somit wird die Last während der Zeitspanne Tlow2 (kurz) in dem Zeitfenster Z2 vollständig von der Versorgung getrennt.

Ist hingegen noch mindestens ein drittes Halbleiterschalter-Paar parallel geschaltet, kann dieses - bei korrekter Schaltung - eine Art Notlaufbetrieb ermöglichen. Denn das mindestens eine dritte Halbleiterschalter-Paar wird während der Zeitspanne Tlow2 mit Hilfe mindestens eines dritten Ansteuersignals, welches während der Zeitspanne Tlow2 einen HIGH-Pegel annimmt, sich in einem geschlossenen Zustand befinden. Demzufolge ist die Last nicht vom System und der Stromversorgung getrennt und wird folglich nicht abgeschaltet.

**Patentansprüche**

1. System zum Erkennen eines nicht schaltenden Halbleiterschalters, wobei das System aufweist:

einen ersten, mittels eines ersten Ansteuersignals ansteuerbaren Halbleiterschalter (34a) und ein erstes Halbleiterbauelement (34b; 34c), das ausgebildet und angeordnet ist, einen Stromfluss durch das erste Halbleiterbauelement (34b; 34c) zumindest in eine Richtung zu verhindern;
einen zweiten, mittels eines zweiten Ansteuersignals ansteuerbaren und zu dem ersten Hableiterschalter (34a) parallel geschalteten Halbleiterschalter (36a) und ein zweites Halbleiterbauelement (36b; 36c), das ausgebildet und angeordnet ist, einen Stromfluss durch das zweite Halbleiterbauelement (36b; 36c) zumindest in eine Richtung zu verhindern;
einen ersten Widerstand (64a), wobei ein Ende des ersten Widerstands (64a) zwischen den ersten Halbleiterschalter (34a) und das erste Halbleiterbauelement (34b; 34c) geschaltet ist und ein anderes Ende des ersten Widerstands (64a) mit einem Bezugspotential, beispielsweise mit Masse, verbunden ist;
einen zweiten Widerstand (66a), wobei ein Ende des zweiten Widerstands (66a) zwischen den zweiten Halbleiterschalter (36a) und das zweite Halbleiterbauelement (36b; 36c) geschaltet ist und ein anderes Ende des zweiten Widerstands (66a) mit dem Bezugspotential, beispielsweise mit Masse, verbunden ist; und

eine Ermittlungseinheit (38), die ausgebildet ist, basierend auf einem Verlauf einer ersten über dem ersten Widerstand (64a) abfallenden Spannung zu erkennen, ob der erste Halbleiterschalter (34a) nicht schaltet, und die ausgebildet ist, basierend auf einem Verlauf einer zweiten über dem zweiten Widerstand (66a) abfallenden Spannung zu erkennen, ob der zweite Halbleiterschalter (36a) nicht schaltet, **dadurch gekennzeichnet, dass** die Ermittlungseinheit (38) aufweist:

eine erste Vergleichskomponente (70a), beispielsweise einen ersten Komparator, die ausgebildet ist, einen ersten Vergleichsverlauf zu ermitteln durch Vergleichen des Verlaufs der ersten Spannung mit einem Verlauf einer über einem Referenzwiderstand (62b) abfallenden Referenzspannung; und
eine zweite Vergleichskomponente (70b), beispielsweise einen zweiten Komparator, die ausgebildet ist, einen zweiten Vergleichsverlauf zu ermitteln durch Vergleichen des Verlaufs der zweiten Spannung mit dem Verlauf der über dem Referenzwiderstand (62b) abfallenden Referenzspannung.

2.  System nach Anspruch 1, wobei

das erste Halbleiterbauelement (34b; 34c) als erste Halbleiterdiode (34c) ausgebildet ist und die erste Halbleiterdiode (34c) angeordnet ist, mit dem ersten Widerstand (64a) einen Pfad zu bilden, wenn der erste Halbleiterschalter (34a) sich in einem offenen Zustand befindet, und die erste Halbleiterdiode (34c) ausgebildet ist, einen Stromfluss durch den gebildeten Pfad zu verhindern, wenn sich der erste Halbleiterschalter (34a) in dem offenen Zustand befindet; und/oder
das zweite Halbleiterbauelement (36b; 36c) als zweite Halbleiterdiode (36c) ausgebildet ist und die zweite Halbleiterdiode (36c) angeordnet ist, mit dem zweiten Widerstand (66a) einen Pfad zu bilden, wenn der zweite Halbleiterschalter (36a) sich in einem offenen Zustand befindet, und die zweite Halbleiterdiode (36c) ausgebildet ist, einen Stromfluss durch den gebildeten Pfad zu verhindern, wenn sich der zweite Halbleiterschalter (36a) in dem offenen Zustand befindet.

3.  System nach Anspruch 1, wobei

das erste Halbleiterbauelement (34b; 34c) als Halbleiterschalter (34b) ausgebildet ist, der antiseriell mit dem ersten Halbleiterschalter (34a) verbunden ist; und/oder
das zweite Halbleiterbauelement (36b; 36c) als Halbleiterschalter (36b) ausgebildet ist, der antiseriell mit dem zweiten Halbleiterschalter (36a) verbunden ist.

4.  System nach einem der Ansprüche 1 bis 3, wobei das System aufweist:

eine erste Spannungsteilerschaltung (64), die den ersten Widerstand (64a) und mindestens einen weiteren Widerstand (64b) aufweist, wobei ein Ende der ersten Spannungsteilerschaltung (64) zwischen den ersten Halbleiterschalter (34a) und das erste Hableiterbauelement (34b; 34c) geschaltet ist und ein anderes Ende der ersten Spannungsteilerschaltung (64) mit dem Bezugspotential, beispielsweise mit Masse, verbunden ist; und/oder
eine zweite Spannungsteilerschaltung (66), die den zweiten Widerstand (66a) und mindestens einen weiteren Widerstand (66b) aufweist, wobei ein Ende der zweiten Spannungsteilerschaltung (66) zwischen den zweiten Halbleiterschalter (36a) und das zweite Hableiterbauelement (36b; 36c) geschaltet ist und ein anderes Ende der zweiten Spannungsteilerschaltung (66) mit dem Bezugspotential, beispielsweise mit Masse, verbunden ist.

5.  System nach Anspruch 4, wobei das System einen Referenzspannungsteiler (62) aufweist, der den Referenzwiderstand (62a) und zumindest einen weiteren Widerstand (62b) aufweist.

6.  System nach Anspruch 4, wobei die Ermittlungseinheit (38) aufweist:

eine erste Verknüpfungskomponente (72a), beispielsweise ein XOR-Gatter, wobei die erste Verknüpfungskomponente ausgebildet ist, ein erstes Verknüpfungssignal durch Verknüpfen des ersten Vergleichsverlaufs mit dem ersten Ansteuersignal zu ermitteln; und
eine zweite Verknüpfungskomponente (72b), beispielsweise ein XOR-Gatter, wobei die zweite Verknüpfungskomponente ausgebildet ist, ein zweites Verknüpfungssignal durch Verknüpfen des zweiten Vergleichsverlaufs mit dem zweiten Ansteuersignal zu ermitteln.

7.  System nach Anspruch 6, wobei die Ermittlungseinheit (38) eine dritte Verknüpfungskomponente (74), beispielsweise ein ODER-Gatter, aufweist, wobei die dritte Verknüpfungskomponente (74) ausgebildet ist, ein Ausgangssignal durch Verknüpfen des ersten Verknüpfungssignals mit dem zweiten Verknüpfungssignal zu ermitteln.

8. System nach einem der Ansprüche 1 bis 7, wobei das System ferner ein Verzögerungsglied (76) aufweist, das ausgebildet ist, ein Fehlersignal durch Anwenden einer Einschaltverzögerung zu ermitteln.

9. Verfahren zum Erkennen eines nicht schaltenden Halbleiterschalters, wobei das Verfahren umfasst:

Ansteuern eines ersten Halbleiterschalters (34a) mittels eines ersten Ansteuersignals;
Ansteuern eines zweiten, zu dem ersten Halbleiterschalter (34a) parallel geschalteten Halbleiterschalters (36a) mittels eines zweiten Ansteuersignals;
Erkennen, basierend auf einem Verlauf einer ersten, über einem ersten Widerstand (64a) abfallenden Spannung, ob der erste Halbleiterschalter (34a) nicht schaltet, wobei ein Ende des ersten Widerstands zwischen den ersten Halbleiterschalter (34a) und ein erstes Halbleiterbauelement (34b; 34c) geschaltet ist und ein anderes Ende des ersten Widerstands (64a) mit einem Bezugspotential, beispielsweise mit Masse, verbunden ist, wobei das erste Halbleiterbauelement (34b; 34c) ausgebildet und angeordnet ist, einen Stromfluss durch das erste Halbleiterbauelement (34b; 34c) zumindest in eine Richtung zu verhindern;
Erkennen, basierend auf einem Verlauf einer zweiten, über einem zweiten Widerstand (66a) abfallenden Spannung, ob der zweite Halbleiterschalter (36a) nicht schaltet, wobei ein Ende des zweiten Widerstands (66a) zwischen den zweiten Halbleiterschalter (36a) und ein zweites Halbleiterbauelement (36b; 36c) geschaltet ist und ein anderes Ende des zweiten Widerstands (66a) mit dem Bezugspotential, beispielsweise mit Masse, verbunden ist, wobei das zweite Halbleiterbauelement (36b; 36c) ausgebildet und angeordnet ist, einen Stromfluss durch das zweite Halbleiterbauelement (36b; 36c) zumindest in eine Richtung zu verhindern;
**gekennzeichnet durch**:

Ermitteln eines ersten Vergleichslaufs durch Vergleichen des Verlaufs der ersten Spannung mit einem Verlauf einer über einem Referenzwiderstand (62b) abfallenden Referenzspannung;
Ermitteln eines zweiten Vergleichslaufs durch Vergleichen des Verlaufs der zweiten Spannung mit dem Verlauf der über dem Referenzwiderstand (62b) abfallenden Referenzspannung.

## Claims

1. A system for identifying a non-switching semiconductor switch, wherein the system has:

a first semiconductor switch (34a), which is controllable by means of a first control signal, and a first semiconductor structural element (34b; 34c), which is configured and arranged to prevent a current flow through the first semiconductor structural element (34b; 34c) at least in one direction;
a second semiconductor switch (36a), which is controllable by means of a second control signal, and is connected in parallel with the first semiconductor switch (34a), and a second semiconductor structural element (36b; 36c), which is configured and arranged to prevent a current flow through the second semiconductor structural element (36b; 36c) at least in one direction;
a first resistor (64a), wherein one end of the first resistor (64a) is connected between the first semiconductor switch (34a) and the first semiconductor structural element (34b; 34c) and another end of the first resistor (64a) is connected to a reference potential, for example to ground;
a second resistor (66a), wherein one end of the second resistor (66a) is connected between the second semiconductor switch (36a) and the second semiconductor structural element (36b; 36c) and another end of the second resistor (66a) is connected to the reference potential, for example to ground; and
a determination unit (38), which is configured to identify, based on a profile of a first voltage drop across the first resistor (64a), whether the first semiconductor switch (34a) does not switch, and which is configured to identify, based on a profile of a second voltage drop across the second resistor (66a), whether the second semiconductor switch (36a) does not switch,
**characterised in that** the determination unit (38) has:

a first comparison component (70a), for example a first comparator, which is configured to determine a first comparison profile by comparing the profile of the first voltage with a profile of a reference voltage that drops across a reference resistor (62b); and
a second comparison component (70b), for example a second comparator, which is configured to determine a second comparison profile by comparing the profile of the second voltage with the profile of the reference voltage that drops across the reference resistor (62b).

2. The system according to claim 1, wherein

the first semiconductor structural element (34b; 34c) is configured as first semiconductor diode (34c) and the first semiconductor diode (34c) is arranged to form a path with the first resistor (64a), when the first semiconductor switch (34a) is in an open state, and the first semiconductor diode (34c) is configured to prevent a current flow through the path that has been formed when the first semiconductor switch (34a) is in the open state; and/or the second semiconductor structural element (36b; 36c) is configured as second semiconductor diode (36c) and the second semiconductor diode (36c) is arranged to form a path with the second resistor (66a) when the second semiconductor switch (36a) is in an open state, and the semiconductor diode (36c) is configured to prevent a current flow through the path that has been formed when the second semiconductor switch (36a) is in the open state.

3. The system according to claim 1, wherein

the first semiconductor structural element (34b; 34c) is configured as semiconductor switch (34b), which is anti-serially connected to the first semiconductor switch (34a); and/or the second semiconductor structural element (36b; 36c) is configured as semiconductor switch (36b), which is anti-serially connected to the second semiconductor switch (36a).

4. The system according to any one of claims 1 to 3, wherein the system has:

a first voltage divider circuit (64), which has the first resistor (64a) and at least one further resistor (64b), wherein an end of the first voltage divider circuit (64) is connected between the first semiconductor switch (34a) and the first semiconductor structural element (34b; 34c) and another end of the first voltage divider circuit (64) is connected to the reference potential, for example to ground; and/or a second voltage divider circuit (66), which has the second resistor (66a) and at least one further resistor (66b), wherein an end of the second voltage divider circuit (66) is connected between the second semiconductor switch (36a) and the second semiconductor structural element (36b; 36c) and another end of the second voltage divider circuit (66) is connected to the reference potential, for example to ground.

5. The system according to claim 4, wherein the system has a reference voltage divider (62), which has the reference resistor (62a) and at least one further resistor (62b).

6. The system according to claim 4, wherein the determination unit (38) has:

a first linkage component (72a), for example an XOR gate, wherein the first linkage component is configured to determine a first linkage signal by combining the first comparison profile with the first control signal; and a second linkage component (72b), for example an XOR gate, wherein the second linkage component is configured to determine a second lo linkage gic signal by combining the second comparison profile with the second control signal.

7. The system according to claim 6, wherein the determination unit (38) has a third linkage component (74), for example an OR gate, wherein the third linkage component (74) is configured to determine an output signal by combining the first linkage signal with the second linkage signal.

8. The system according to any one of claims 1 to 7, wherein the system further has a delay member (76), which is configured to determine a fault signal by applying a switch-on delay.

9. A method for identifying a non-switching semiconductor switch, wherein the method comprises:

controlling a first semiconductor switch (34a) by means of a first control signal; controlling a second semiconductor switch (36a), connected in parallel with the first semiconductor switch (34a), by means of a second control signal; identifying, based on a profile of a first voltage drop across a first resistor (64a), whether the first semiconductor switch (34a) does not switch, wherein an end of the first resistor is connected between the first semiconductor switch (34a) and a first semiconductor structural element (34b; 34c) and another end of the first resistor (64a) is connected to a reference potential, for example to ground, wherein the first semiconductor structural element (34b; 34c) is configured and arranged to prevent a current flow through the first semiconductor structural element (34b; 34c) at least in one direction;

identifying, based on a profile of a second voltage drop across a second resistor (66a), whether the second semiconductor switch (36a) does not switch, wherein an end of the second resistor (66a) is connected between the second semiconductor switch (36a) and a second semiconductor structural element (36b; 36c) and another end of the second resistor (66a) is connected to the reference potential, for example to ground, wherein the second semiconductor structural element (36b; 36c) is configured and arranged to prevent a current flow through the second semiconductor structural element (36b; 36c) at least in one direction;

**characterised by**:

determining a first comparison profile by comparing the profile of the first voltage with a profile of a reference voltage that drops across a reference resistor (62b); and

determining a second comparison profile by comparing the profile of the second voltage with the profile of the reference voltage that drops across the reference resistor (62b).


**Revendications**

1.  Système destiné à l'identification d'un commutateur à semi-conducteurs non commutant, le système comportant :

un premier commutateur (34a) à semi-conducteurs pouvant être commandé au moyen d'un premier signal de commande, et un premier composant semi-conducteur (34b ; 34c) qui est configuré et disposé pour empêcher au moins dans un sens un flux de courant à travers le premier composant semi-conducteur (34b ; 34c) ;
un second commutateur (36a) à semi-conducteurs pouvant être commandé au moyen d'un second signal de commande, et connecté en parallèle au premier commutateur (34a) à semi-conducteurs et un second composant semi-conducteur (36b ; 36c) qui est configuré et disposé pour empêcher au moins dans un sens un flux de courant à travers le second composant semi-conducteur (36b ; 36c) ;
une première résistance (64a), une extrémité de la première résistance (64a) étant connectée entre le premier commutateur (34a) à semi-conducteurs et le premier composant semi-conducteur (34b ; 34c) et une autre extrémité de la première résistance (64a) étant raccordée à un potentiel de référence, par exemple à la masse ;
une seconde résistance (66a), une extrémité de la seconde résistance (66a) étant connectée entre le second commutateur (36a) à semi-conducteurs et le second composant semi-conducteur (36b ; 36c) et une autre extrémité de la seconde résistance (66a) étant raccordée au potentiel de référence, par exemple à la masse ; et
une unité de détermination (38) qui est configurée pour déterminer, sur la base d'une courbe d'une première tension diminuant sur la première résistance (64a), si le premier commutateur (34a) à semi-conducteurs ne commute pas, et qui est configurée pour déterminer, sur la base d'une courbe d'une seconde tension diminuant sur la seconde résistance (66a), si le second commutateur (36a) à semi-conducteurs ne commute pas,
**caractérisé en ce que** l'unité de détermination (38) comporte :

un premier composant de comparaison (70a), par exemple un premier comparateur, qui est configuré pour déterminer une première courbe de comparaison par comparaison de la courbe de la première tension avec une courbe d'une tension de référence diminuant sur une résistance de référence (62b) ; et
un second composant de comparaison (70b), par exemple un second comparateur, qui est configuré pour déterminer une seconde courbe de comparaison par comparaison de la courbe de la seconde tension avec la courbe de la tension de référence diminuant sur la résistance de référence (62b).

2.  Système selon la revendication 1, dans lequel

le premier composant semi-conducteur (34b ; 34c) est configuré sous forme de première diode à semi-conducteur (34c) et la première diode à semi-conducteur (34c) est disposée pour former une voie avec la première résistance (64a) lorsque le premier commutateur (34a) à semi-conducteurs se trouve en un état ouvert, et la première diode à semi-conducteur (34c) est configurée pour empêcher un flux de courant à travers la voie formée, lorsque le premier commutateur (34a) à semi-conducteurs se trouve en l'état ouvert ; et/ou
le second composant semi-conducteur (36b ; 36c) est configuré sous forme de seconde diode à semi-conducteur (36c) et la seconde diode à semi-conducteur (36c) est disposée pour former une voie avec la seconde résistance (66a) lorsque le second commutateur (36a) à semi-conducteurs se trouve en un état ouvert, et la seconde diode à semi-conducteur (36c) est configurée pour empêcher un flux de courant à travers la voie formée, lorsque le second commutateur (36a) à semi-conducteurs se trouve en l'état ouvert.

3. Système selon la revendication 1, dans lequel

le premier composant semi-conducteur (34b ; 34c) est configuré en tant que commutateur (34b) à semi-conducteurs qui est raccordé en anti-série au premier commutateur (34a) à semi-conducteurs ; et/ou
le second composant semi-conducteur (36b ; 36c) est configuré en tant que commutateur (36b) à semi-conducteurs qui est raccordé en anti-série au second commutateur (36a) à semi-conducteurs.

4. Système selon l'une quelconque des revendications 1 à 3, le système comportant :

un premier circuit potentiométrique (64) qui comporte la première résistance (64a) et au moins une résistance supplémentaire (64b), une extrémité du premier circuit potentiométrique (64) étant connectée entre le premier commutateur (34a) à semi-conducteurs et le premier composant semi-conducteur (34b ; 34c) et une autre extrémité du premier circuit potentiométrique (64) étant raccordée au potentiel de référence, par exemple à la masse ; et/ou
un second circuit potentiométrique supplémentaire (66) qui comporte la seconde résistance (66a) et au moins une résistance supplémentaire (66b), une extrémité du second circuit potentiométrique (66) étant connectée entre le second commutateur (36a) à semi-conducteurs et le second composant semi-conducteur (36b ; 36c) et une autre extrémité du second circuit potentiométrique (66) étant raccordée au potentiel de référence, par exemple à la masse.

5. Système selon la revendication 4, le système comportant un potentiomètre de référence (62) qui comporte la résistance de référence (62a) et au moins une résistance supplémentaire (62b).

6. Système selon la revendication 4, dans lequel l'unité de détermination (38) comporte :

un premier composant de jonction (72a), par exemple une porte XOR, le premier composant de jonction étant configuré pour déterminer un premier signal de jonction par combinaison de la première courbe de comparaison avec le premier signal de commande ; et
un deuxième composant de jonction (72b), par exemple une porte XOR, le deuxième composant de jonction étant configuré pour déterminer un second signal de jonction par combinaison de la seconde courbe de comparaison avec le second signal de commande.

7. Système selon la revendication 6, dans lequel l'unité de détermination (38) comporte un troisième composant de jonction (74), par exemple une porte OU, le troisième composant de jonction (74) étant configuré pour déterminer un signal de sortie par combinaison du premier signal de jonction avec le second signal de jonction.

8. Système selon l'une quelconque des revendications 1 à 7, dans lequel le système comporte en outre un dispositif de temporisation (76) qui est configuré pour déterminer un signal d'erreur par application d'une temporisation de mise en circuit.

9. Procédé pour l'identification d'un commutateur à semi-conducteurs non commutant, le procédé comprenant les étapes consistant à :

commander un premier commutateur (34a) à semi-conducteurs au moyen d'un premier signal de commande ;
commander un second commutateur (36a) à semi-conducteurs, connecté en parallèle au premier commutateur (34a) à semi-conducteurs, au moyen d'un second signal de commande ;
déterminer, sur la base d'une courbe d'une première tension diminuant sur une première résistance (64a), si le premier commutateur (34a) à semi-conducteurs ne commute pas, une extrémité de la première résistance étant connectée entre le premier commutateur (34a) à semi-conducteurs et un premier composant semi-conducteur (34b ; 34c) et une autre extrémité de la première résistance (64a) étant raccordée à un potentiel de référence, par exemple à la masse, le premier composant semi-conducteur (34b ; 34c) étant configuré et étant disposé pour empêcher au moins dans un sens un flux de courant à travers le premier composant semi-conducteur (34b ; 34c) ;
déterminer, sur la base d'une courbe d'une seconde tension diminuant sur une seconde résistance (66a), si le second commutateur (36a) à semi-conducteurs ne commute pas, une extrémité de la seconde résistance (66a) étant connectée entre le second commutateur (36a) à semi-conducteurs et un second composant semi-conducteur (36b ; 36c) et une autre extrémité de la seconde résistance (66a) étant raccordée au potentiel de référence, par exemple à la masse, le second composant semi-conducteur (36b ; 36c) étant configuré et disposé pour empêcher au moins dans un sens un flux de courant à travers le second composant semi-conducteur (36b ; 36c) ;

**caractérisé par** les étapes consistant à :

déterminer une première courbe de comparaison par comparaison de la courbe de la première tension avec une courbe d'une tension de référence diminuant sur une résistance de référence (62b) ; et
déterminer une seconde courbe de comparaison par comparaison de la courbe de la seconde tension avec la courbe de la tension de référence diminuant sur la résistance de référence (62b).

Fig. 1

Fig. 2

EP 4 107 535 B1

Fig. 3a

EP 4 107 535 B1

Fig. 3b

Fig. 4a

Fig. 4b

**IN DER BESCHREIBUNG AUFGEFÜHRTE DOKUMENTE**

**In der Beschreibung aufgeführte Patentdokumente**

- DE 4301605 C1
- EP 2645511 A1
- EP 3460593 A1